# EUROPEAN PATENT SPECIFICATION

(11) **EP 2 887 416 B1**
(45) Date of publication and mention of the grant of the patent: **21.02.2018**
(21) Application number: 14171326.3
(22) Date of filing: 05.06.2014
(51) Int. Cl.: H01L 51/54, H01L 51/50

(54) **N-doped semiconducting material comprising phosphine oxide matrix and metal dopant**
N-dotiertes Halbleitermaterial mit Phosphinoxidmatrix und Metalldotiermittel
Matériau semi-conducteur dopé N comprenant une matrice d'oxyde de phosphine et un dopant de métal

(30) Priority: 23.12.2013 EP 13199413
(43) Date of publication of application: 24.06.2015
(73) Proprietor: Novaled GmbH, 01307 Dresden (DE)
(72) Inventor: Fadhel, Omrane, 01099 Dresden (DE); Rothe, Carsten, 01326 Dresden (DE); Birnstock, Jan, 01187 Dresden (DE); Werner, Ansgar, 01277 Dresden (DE); Gilge, Kai, 01307 Dresden (DE); Angermann, Jens, 01328 Dresden (DE); Zöllner, Mike, 01307 Dresden (DE); Bloom, Francisco, 5642 KZ Eindhoven (NL); Rosenow, Thomas, 01069 Dresden (DE); Canzler, Tobias, 01099 Dresden (DE); Kalisz, Tomas, 01307 Dresden (DE); Denker, Ulrich, 01307 Dresden (DE)
(74) Representative: Bittner, Thomas L.

(56) References cited:
- JP-A- 2006 073 581
- US-A- 6 013 384
- LINDA S. SAPOCHAK ET AL: "<title>Design strategies for achieving high triplet energy electron transporting host materials for blue electrophosphorescence</title>", PROCEEDINGS OF SPIE, vol. 6333, 31 August 2006 (2006-08-31), page 63330F, XP055186526, ISSN: 0277-786X, DOI: 10.1117/12.684126

## Description

The present invention concerns organic semiconducting material with improved electrical properties, process for its preparation, and electronic device utilizing the improved electrical properties of the inventive semiconducting material, particularly the device comprising this organic semiconducting material in an electron transporting and/or electron injecting layer and electron transport matrix compound applicable in semiconducting material of present invention.

### I. BACKGROUND OF THE INVENTION

Among the electronic devices comprising at least a part based on material provided by organic chemistry, organic light emitting diodes (OLEDs) have a prominent position. Since the demonstration of efficient OLEDs by Tang et al. in 1987 (C.W. Tang et al., Appl. Phys. Lett. 51 (12), 913 (1987)), OLEDs developed from promising candidates to high-end commercial displays. An OLED comprises a sequence of thin layers substantially made of organic materials. The layers typically have a thickness in the range of 1 nm to 5 µm. The layers are usually formed either by means of vacuum deposition or from a solution, for example by means of spin coating or jet printing.

OLEDs emit light after the injection of charge carriers in the form of electrons from the cathode and in form of holes from the anode into organic layers arranged in between. The charge carrier injection is effected on the basis of an applied external voltage, the subsequent formation of excitons in a light emitting zone and the radiative recombination of those excitons. At least one of the electrodes is transparent or semitransparent, in the majority of cases in the form of a transparent oxide, such as indium tin oxide (ITO), or a thin metal layer.

Among the matrix compounds used in OLED light emitting layers (LELs) or electron transporting layers (ETLs), important position have the compounds that comprise at least one phosphine oxide group. The reason why the phosphine oxide group often significantly improves the electron injecting and/or electron transporting properties of the semiconducting material is not yet fully understood. It is believed that the high dipole moment of the phosphine oxide group plays somehow the positive role. Especially recommended for this use are triaryl phosphine oxides comprising at least one condensed aromatic or heteroaromatic group attached directly to the phosphine oxide group, see e.g. JP 4 876 333 B2.

Electrical doping of charge transporting semiconducting materials for improving their electrical properties, especially conductivity, is known since nineties of the 20^{th} century, e.g. from US 5 093 698 A. An especially simple method for n-doping in ETLs prepared by the thermal vacuum deposition, which is currently the standard method most frequently used, e.g. in industrial manufacture of displays, is evaporation of a matrix compound from one evaporation source and of a highly electropositive metal from another evaporation source and their co-deposition on a solid substrate. As useful n-dopants in triaryl phosphine oxide matrix compounds, alkaline metals and alkaline earth metals were recommended in JP 4 725 056 B2, with caesium as the dopant successfully used in the given examples. Indeed, caesium as the most electropositive metal offers the broadest freedom in the choice of a matrix material, and it is likely the reason why solely caesium was the n-doping metal of choice in the cited document.

For an industrial use, caesium as a dopant has several serious drawbacks. First, it is very reactive, moisture and highly air sensitive material that renders any handling difficult and incurs significant additional costs for mitigating the high safety and fire hazard unavoidably linked with its use. Second, its quite low normal boiling point (678 °C) indicates that it may be highly volatile under high vacuum conditions. Indeed, at pressures below 10⁻³ Pa used in industrial equipment for vacuum thermal evaporation (VTE), caesium metal evaporates significantly already at slightly elevated temperature. Taking into account the evaporation temperatures for typical matrix compounds used in organic semiconducting materials at pressures below 10⁻³ Pa are typically between 150-400 °C, avoiding an uncontrolled caesium evaporation, resulting in its undesired deposition contaminating the colder parts of the whole equipment (e.g. the parts that are shielded against heat radiation from the organic matrix evaporation source), is a really challenging task.

Several methods for overcoming these drawbacks and enabling industrial applicability of caesium for n-doping in organic electronic devices have been published. For safe handling, caesium may be supplied in hermetic shells that open just inside the evacuated evaporation source, preferably during heating to the operational temperature. Such technical solution was provided e.g. in WO 2007/065685, however, it does not solve the problem of caesium high volatility.

US 7 507 694 B2 or EP 1 648 042 B1 offer another solution in form of caesium alloys that melt at low temperature and show significantly decreased caesium vapour pressure in comparison with the pure metal. Yet, these alloys are still highly air and moisture sensitive. Moreover, this solution has further drawback in the fact that the vapour pressure over the alloy changes with the decreasing caesium concentration during the evaporation. That creates new problem of an appropriate deposition rate control, e.g. by programming the temperature of the evaporation source. So far, quality assurance (QA) concerns regarding robustness of such process on an industrial scale hamper a wider application of this technical solution in mass production processes.

A viable alternative to Cs doping represent highly electropositive transition metal complexes like W₂(hpp)₄ that have ionisation potentials comparably low as caesium and volatilities comparable with volatilities of usual organic matrices. Indeed, these complexes disclosed as electrical dopants first in WO2005/086251 are very efficient for most electron transporting matrices except some hydrocarbon matrices. Despite their high air and moisture sensitivity, these metal complexes provide satisfactory n-doping solution for an industrial use, if supplied in the shells according to WO 2007/065685. Its main disadvantage is their high price caused by relative chemical complexity of comprised ligands and necessity of a multistep synthesis of the final complex, as well as additional costs incurred by necessity of using the protective shells and/or by the QA and logistic issues linked with shell recycling and refilling.

Another alternative represent strong n-dopants created in situ in the doped matrix from relatively stable precursors by an additional energy supplied e.g. in form of ultraviolet (UV) or visible light of an appropriate wavelength. Appropriate compounds for this solution were provided e.g. in WO2007/107306 A1. Nevertheless, state-of-the-art industrial evaporation sources require materials with very high thermal stability, allowing their heating to the operational temperature of the evaporation source without any decomposition during the whole operating cycle (e.g., for a week at 300 °C) of the source loaded with the material to be evaporated. Providing organic n-dopants or n-dopant precursors with such long-term thermal stability is a real technical challenge so far. Moreover, the complicated arrangement of the production equipment that must ensure a defined and reproducible additional energy supply for achieving reproducibly the desired doping level (through the in situ activation of the dopant precursor deposited in the matrix) represents an additional technical challenge and a potential source of additional CA issues in mass production.

Yook et al (Advanced Functional Materials 2010, 20, 1797-1802) successfully used caesium azide in laboratory as an air-stable Cs precursor. This compound is known to decompose under heating above 300 °C to caesium metal and elemental nitrogen. This process is, however, hardly applicable in contemporary industrial VTE sources, due to difficult control of such decomposition reaction in a larger scale. Moreover, release of nitrogen gas as a byproduct in this reaction brings a high risk that especially at higher deposition rates desired in the mass production, the expanding gas will expel solid caesium azide particles from the evaporation source, causing thus high defect counts in the deposited layers of doped semiconducting materials.

Another alternative approach for electrical n-doping in electron transporting matrices is doping with metal salts or metal complexes. The most frequently used example of such dopant is lithium 8-hydroxy-quinolinolate (LiQ). It is especially advantageous in matrices comprising a phosphine oxide group; see e.g. WO 2012/173370 A2. The main disadvantage of metals salt dopants is that they improve basically only electron injection to the adjacent layers and do not increase the conductivity of doped layers. Their utilization for decreasing the operational voltage in electronic devices is thus limited on quite thin electron injecting or electron transporting layers and does hardly allow e.g. an optical cavity tuning by using ETLs thicker than approximately 25 nm, what is well possible with redox-doped ETLs having high conductivity.

For the above reasons, and especially for electrical doping in ETLs thicker than approximately 30 nm, the current technical practice prefers lithium as an industrial redox n-dopant (see e.g. US 6 013 384 B2). This metal is relatively cheap and differs from other alkaline metals by its somewhat lower reactivity and, especially, by its significantly lower volatility (normal boiling point about 1340 °C), allowing its evaporation in the VTE equipment at temperatures between 350-550 °C.

Nevertheless, quite in accordance with its high n-doping power allowing Li to dope majority of usual types of electron transporting matrices, this metal possesses also a high degree of reactivity. It reacts under ambient temperature even with dry nitrogen and for its use in a highly reproducible manufacturing process complying with contemporary industrial QA standards, it must be stored and handled exclusively under high purity noble gases. Moreover, if Li is co-evaporated with matrix compounds that have evaporation temperatures in the range 150-300 °C, its significantly higher evaporation temperature in comparison with the matrix evaporation temperature already causes cross-contamination problems in the VTE equipment.

Many documents suggest as alternative n-dopants almost any known metallic element including weakly reductive and highly volatile Zn, Cd, Hg, weakly reductive Al, Ga, In, Tl, Bi, Sn, Pb, Fe, Co, Ni, or even noble metals like Ru, Rh, Ir and/or refractory metals with highest known boiling points like Mo, W, Nb, Zr (see e.g. JP 2009/076508 or WO 2009/106068). Unfortunately, not only in these two documents cited here as examples but throughout the scientific and patent literature overall, there is in fact lack of any evidence that some of these suggestions have ever been experimentally tested.

To be more specific, even WO 2009/106068 that does not merely mention all imaginable dopants but really strives to claim all the named metalloid elements as n-dopants in organic electronic devices due their alleged applicability through a high-temperature decomposition of a gaseous precursor compound in a heated nozzle, does not bring any single numeric value documenting the physical parameters of allegedly prepared doped materials and/or technical performance of allegedly prepared devices.

On the other hand, US2005/0042548 published before the date of priority of WO 2009/106068 teaches in paragraph 0069 (see namely the last two lines of the left column and first three lines of the right column on page 7) that iron pentacarbonyl can be used for n-doping in organic ETMs if the compound is activated by UV radiation which splits off a carbon monoxide ligand. The coordinatively unsaturated iron compound then reacts with the matrix, what results in the observed doping effects. In the light of this previous art showing that the metal carbonyls that were used in the alleged working example of WO 2009/106068 are known n-dopants in organic matrices if activated by supply of additional energy, it seems quite likely that if the applicants of WO2009/106068 really obtained with their jet of iron pentacarbonyl flowing through a ceramic nozzle electrically heated to a white glow (see the last paragraph of the German text on page 12 of the cited PCT application) any doping effect in the target bathocuproin layer, this effect was caused rather by the same coordinatively unsaturated iron carbonyl complex as produced by UV irradiation in US2005/0042548, than with elemental iron as they suggest. This suspicion is further supported by the fourth paragraph on page 13 of the cited PCT application which teaches that the same result can be obtained with a cold nozzle, if the stream of iron pentacarbonyl is irradiated with an infrared laser having the wavelength fitting with the absorption frequency of the CO groups in the iron pentacarbonyl complex. Here, it is even more likely that the laser activation resulted not in naked metal atoms or clusters of metal atoms but in a reactive coordinately unsaturated iron complex still bearing some carbonyl ligands, analogously to the reactive complex formed by activation with the UV light.

Despite metals with strongly negative standard redox potentials like alkali earth metals or lanthanides are recited as alternative n-dopants besides alkali metals basically in each document dealing with redox n-doping, the record of the proven n-doping with any metal different from alkali metals is very scarce.

Magnesium is in comparison with alkaline metals much less reactive. It reacts even with liquid water at the ordinary temperature very slowly and in air it keeps its metallic luster and does not gain weight for months. It may be thus considered as practically air-stable. Moreover, it has low normal boiling point (about 1100 °C), very promising for its VTE processing in an optimum temperature range for co-evaporation with organic matrices.

On the other hand, the authors of the present application confirmed in a screening done with dozens of state-of-the-art ETMs that Mg does not possess a sufficient doping strength for usual ETMs. The only favourable result has been achieved in OLEDs comprising thin electron injection layers consisting of a specific kind of triaryl phosphine oxide matrix (comprising a special tris-pyridyl unit designed for chelating metals), doped with magnesium, as shown in EP 2 452 946 A1. Despite the structural specifity and very favourable (in terms of its LUMO level which is quite deep under the vacuum level in the absolute energy scale) dopability of the exemplary matrix tested with magnesium in EP 2 452 946 A1, the positive results achieved with this n-doped semiconducting material encouraged further research focused on n-doping with substantially air stable metals.

US6013384 A discloses an organic electroluminescent device including at least one luminescent layer having an organic compound doped with a metal capable of acting as a donor dopant, in adjacent to a cathode electrode.

JP2006073581 discloses a light emitting device and a material thereof containing a phosphine oxide compound and an alkali metal or alkaline earth metal.

It is an object of the invention to overcome the drawbacks of the prior art and to provide effectively n-doped semiconducting materials utilizing substantially air stable metals as n-dopants, especially in ETMs having their lowest unoccupied molecular orbital (LUMO) energy levels closer to vacuum level that in terms of easier measurable cyclovoltammetric electrochemical redox potentials corresponds to more negative values than about -2.25 V against ferrocenium/ferrocene reference.

It is a further object of the invention to provide alternative metallic elements which are substantially air stable and can be successfully embedded (preferably by standard VTE processes and using contemporary evaporation sources) in electrically doped semiconducting materials for use in electronic devices.

A third object of the invention is to provide a process for manufacturing the semiconducting material utilizing substantially air stable metals as n-dopants.

A fourth object of the invention is to provide devices with better characteristics, especially with low voltage and, more specifically, OLEDs with low voltage and high efficiency.

A fifth object of the invention is to provide new matrix compounds applicable in semiconducting materials according to the invention.

### II. SUMMARY OF THE INVENTION

The above objects are achieved in accordance with the subject-matter of the independent claims. Preferred embodiments result from the sub-claims.

The object is achieved by an electrically doped semiconducting material comprising at least one metallic element in its substantially elemental form as n-dopant and as an electron transport matrix at least one compound comprising at least one phosphine oxide group, wherein the metallic element is selected from elements that form in their oxidation number II at least one stable compound and the electron transport matrix compound has a reduction potential, if measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, preferably lower than 2,4,7,9-tetraphenyl-1,10-phenanthroline, even more preferably lower than 9,10-di(naphthalen-2-yl)-2-phenylanthracene, even more preferably lower than 2,9-bis(2-methoxyphenyl)-4,7-diphenyl-1,10-phenanthroline, most preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene.

Under "stable compound", it is to be understood a compound that is, at the normal temperature 25°C, thermodynamically and/or kinetically stable enough that it could be prepared and the oxidation state II for the metallic element could be proven.

It is preferred that the electron transport matrix compound is a compound according to formula (I): 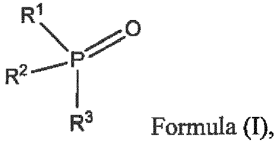 wherein R¹, R² and R³ are independently selected from C₁-C₃₀-alkyl, C₃-C₃₀ cycloalkyl, C₂-C₃₀-heteroalkyl, C₆-C₃₀-aryl, C₂-C₃₀-heteroaryl, C₁-C₃₀-alkoxy, C₃-C₃₀-cycloalkyloxy, C₆-C₃₀-aryloxy, wherein each of the substituents R¹, R² and R³ optionally comprises further phosphine oxide groups and at least one of the substituents R¹, R² and R comprises a conjugated system of at least 10 delocalized electrons.

Examples of conjugated systems of delocalized electrons are systems of alternating pi- and sigma bonds. Optionally, one or more two-atom structural units having the pi-bond between its atoms can be replaced by an atom bearing at least one lone electron pair, typically by a divalent atom selected from O, S, Se, Te or by a trivalent atom selected from N, P, As, Sb, Bi. Preferably, the conjugated system of delocalized electrons comprises at least one aromatic ring adhering to the Hückel rule. More preferably, the conjugated system of delocalized electrons comprises a condensed aromatic skeleton comprising at least 10 delocalized electrons, e.g. a naphthalene, anthracene, phenanthrene, pyrene, quinoline, indole or carbazole skeleton. Also preferably, the conjugated system of delocalized electrons may consist of at least two directly attached aromatic rings, the simplest examples of such systems being biphenyl, bithienyl, phenylthiophene, phenylpyridine and like.

Also preferably, the metallic element has the sum of its first and second ionization potential lower than 25 eV, more preferably lower than 24 eV, even more preferably lower than 23.5 eV, most preferably lower than 23.1 eV.

In one of preferred embodiments, the conjugated system of at least 10 delocalized electrons is attached directly to the phosphine oxide group.

In another preferred embodiment, the conjugated system of at least 10 delocalized electrons is separated from the phosphine oxide group by a spacer group A. The spacer group A is preferably a divalent six-membered aromatic carbocyclic or heterocyclic group, more preferably, the spacer group A is selected from phenylene, azine-2,4-diyl, azine-2,5-diyl, azine-2,6-diyl, 1,3-diazine-2,4-diyl and 1,3-diazine-2,5-diyl.

It is further preferred that the conjugated system of at least 10 delocalized electrons is a C₁₄-C₅₀-aryl or a C₈-C₅₀ heteroaryl.

In one of preferred embodiments, the electrically doped semiconducting material further comprises a metal salt additive consisting of at least one metal cation and at least one anion. Preferably, the metal cation is Li⁺ or Mg²⁺. Also preferably, the metal salt additive is selected from metal complexes comprising a 5-, 6- or 7- membered ring that contains a nitrogen atom and an oxygen atom attached to the metal cation and from complexes having the structure according to formula (II) 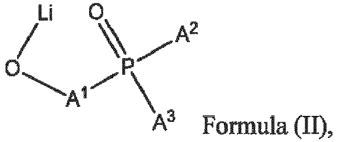 wherein A¹ is a C₆-C₃₀ arylene or C₂-C₃₀ heteroarylene comprising at least one atom selected from O, S and N in an aromatic ring and each of A² and A³ is independently selected from a C₆-C₃₀ aryl and C₂-C₃₀ heteroaryl comprising at least one atom selected from O, S and N in an aromatic ring. Equally preferably, the anion is selected from the group consisting of phenolate substituted with a phosphine oxide group, 8-hydroxyquinolinolate and pyrazolylborate. The metal salt additive preferably works as a second electrical n-dopant, more preferably, it works synergistically with the metallic element present in the elemental form and works as the first electrical n-dopant.

The second object of the invention is achieved by using a metal selected from Mg, Ca, Sr, Ba, Yb, Sm, Eu and Mn as an electrical n-dopant in any of electrically doped semiconducting materials defined above.

The third object of the invention is achieved by process for manufacturing the semiconducting material, comprising a step where the electron transport matrix compound comprising at least one phosphine oxide group and the metallic element selected from elements that form in their oxidation number II at least one stable compound are co-evaporated and co-deposited under reduced pressure, wherein the electron transport matrix compound has the reduction potential, if measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, preferably lower than 2,4,7,9-tetraphenyl-1,10-phenanthroline, more preferably lower than 9,10-di(naphthalen-2-yl)-2-phenylanthracene, even more preferably lower than 2,9-bis(2-methoxyphenyl)-4,7-diphenyl-1,10-phenanthroline, most preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than 4,4'-di(9H-carbazol-9-yl)-1,1'-biphenyl, even more preferably higher than bis(4-(9H-carbazol-9-yl)phenyl)(phenyl)phosphine oxide, most preferably higher than 3-([1,1'-biphenyl]-4-yl)-5-(4-(tert-butyl)phenyl)-4-phenyl-4H-1,2,4-triazole.

Preferably, the metallic element has normal boiling point lower than 3000 °C, more preferably lower than 2200 °C, even more preferably lower than 1800 °C, most preferably lower than 1500°C. Under normal boiling point, it is to be understood the boiling point at normal atmospheric pressure (101.325 kPa). Also preferably, the metallic element has the sum of its first and second ionization potential higher than 16 eV, slightly more preferably higher than 17 eV, more preferably higher than 18 eV, even more preferably higher than 20 eV, most preferably higher than 21 eV, less but still preferably higher than 22 eV and even less but still preferably higher than 23 eV. It is preferred that the metallic element is substantially air stable. Preferably, the metallic element is selected from Mg, Ca, Sr, Ba, Yb, Sm, Eu and Mn, more preferably from Mg and Yb. Most preferably, the metallic element is Mg. Also preferably, the metallic element is evaporated from linear evaporation source. The first object of the invention is achieved also by electrically doped semiconducting material preparable by any of the above described processes according to invention.

Described herein is an electronic device comprising a cathode, an anode and the electrically doped semiconducting material comprising as n-dopant at least one metallic element in its substantially elemental form and at least one electron transport matrix compound comprising at least one phosphine oxide group, wherein the metallic element is selected from elements that form in their oxidation number II at least one stable compound and the electron transport matrix compound has the reduction potential, if measured by cyclic voltammetry under the same conditions, lower than 9,9',10,10'-tetraphenyl-2,2'-bianthracene or 2,9-di([1,1'-biphenyl]-4-yl)-4,7-diphenyl-1,10-phenanthroline, preferably lower than 2,4,7,9-tetraphenyl-1,10-phenanthroline, more preferably lower than 9,10-di(naphthalen-2-yl)-2-phenylanthracene, even more preferably lower than 2,9-bis(2-methoxyphenyl)-4,7-diphenyl-1,10-phenanthroline, most preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene or preparable by a process recited above between the cathode and anode.

Preferred embodiments of the electronic device according to the invention comprise preferred embodiments of the inventive semiconducting material as recited above. More preferably, the preferred embodiments of the electronic device according to invention comprise the inventive semiconducting material prepared by any embodiment of the inventive process characterized above.

Preferably, the electrically doped semiconducting material forms an electron transporting or electron injecting layer. More preferably, the electron transporting or electron injecting layer is adjacent to a light emitting layer consisting of compounds that have their reduction potentials, if measured by cyclic voltammetry under the same conditions, lower than the electron transport matrix compounds of the adjacent electron transporting or electron injecting layer.

It is further preferred that the light emitting layer emits blue or white light. In one of preferred embodiments, the light emitting layer comprises at least one polymer. More preferably, the polymer is a blue light emitting polymer.

Also preferably, the electron transporting or electron injecting layer is thicker than 5 nm, preferably thicker than 10 nm, more preferably thicker than 15 nm, even more preferably thicker than 20 nm and most preferably thicker than 25 nm.

In one of preferred embodiments, the electron transporting or electron injecting layer is adjacent to a cathode consisting of a semiconducting metal oxide. Preferably, the semiconducting metal oxide is indium tin oxide. The cathode may be prepared by sputtering.

The fifth object of the invention is achieved by compound selected from the group consisting of

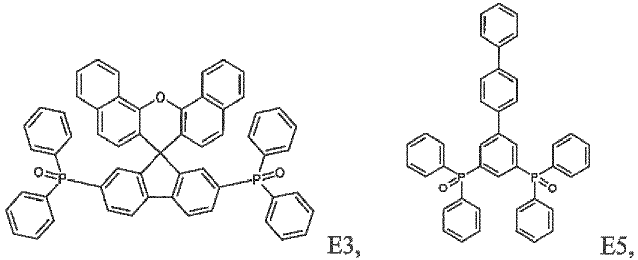

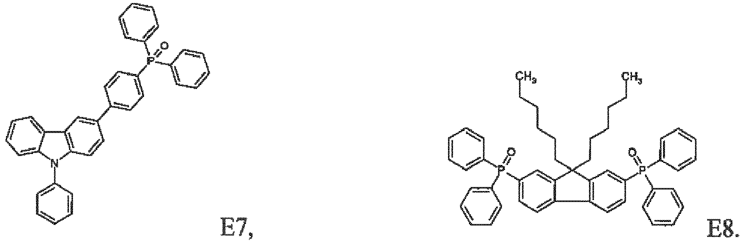

### III. BRIEF DESCRIPTION OF DRAWINGS

FIG. 1 shows a schematic illustration of a device in which the present invention can be incorporated.
FIG. 2 shows a schematic illustration of a device in which the present invention can be incorporated.

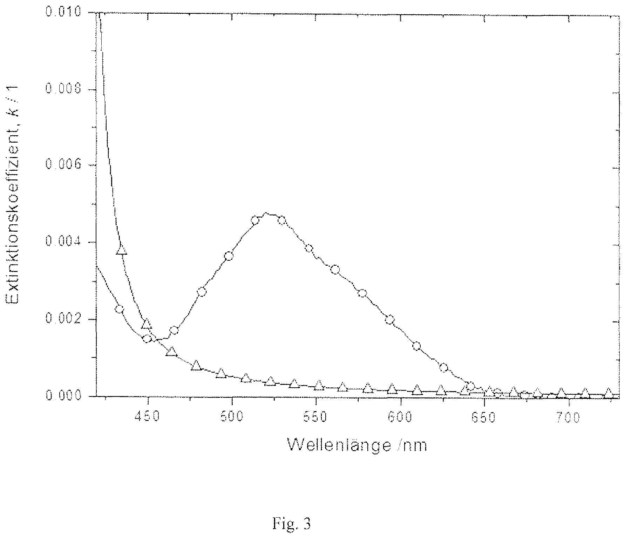

FIG. 3 shows absorbance curves of two n-doped semiconducting materials; circles stand for comparative matrix compound C10 doped with 10 wt% of compound F1 that forms strongly reducing radicals, triangles stand for compound E10 doped with 5 wt% Mg.

### IV. DETAILED DESCRIPTION OF THE INVENTION

### Device Architecture

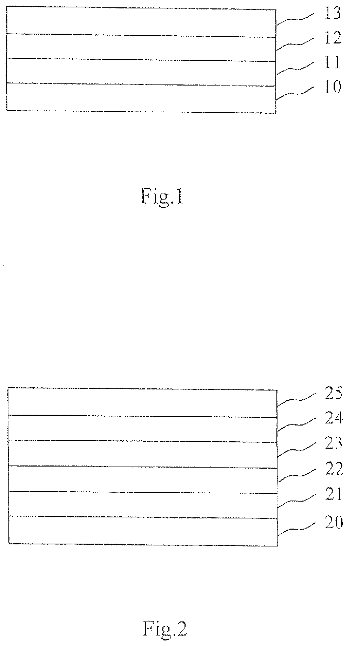

Fig. 1 shows a stack of anode (10), organic semiconducting layer (11) comprising the light emitting layer, electron transporting layer (ETL) (12), and cathode (13). Other layers can be inserted between those depicted, as explained herein.

Fig. 2 shows a stack of an anode (20), a hole injecting and transporting layer (21), a hole transporting layer (22) which can also aggregate the function of electron blocking, a light emitting layer (23), an ETL (24), and a cathode (25). Other layers can be inserted between those depicted, as explained herein.

The wording "device" comprises the organic light emitting diode.

### Material properties - energy levels

A method to determine the ionization potentials (IP) is the ultraviolet photo spectroscopy (UPS). It is usual to measure the ionization potential for solid state materials; however, it is also possible to measure the IP in the gas phase. Both values are differentiated by their solid state effects, which are, for example the polarization energy of the holes that are created during the photo ionization process. A typical value for the polarization energy is approximately 1 eV, but larger discrepancies of the values can also occur. The IP is related to onset of the photoemission spectra in the region of the large kinetic energy of the photoelectrons, i.e. the energy of the most weakly bounded electrons. A related method to UPS, the inverted photo electron spectroscopy (IPES) can be used to determine the electron affinity (EA). However, this method is less common. Electrochemical measurements in solution are an alternative to the determination of solid state oxidation (Eₒₓ) and reduction (E_{red}) potential. An adequate method is, for example, cyclic voltammetry. To avoid confusion, the claimed energy levels are defined in terms of comparison with reference compounds having well defined redox potentials in cyclic voltammetry, when measured by a standardized procedure. A simple rule is very often used for the conversion of redox potentials into electron affinities and ionization potential: IP (in eV) = 4.8 eV + e*Eₒₓ (wherein Eₒₓ is given in volts vs. ferrocenium/ferrocene (Fc⁺/Fc)) and EA (in eV) = 4.8 eV + e*E_{red} (E_{red} is given in volts vs. Fc⁺/Fc) respectively (see B.W. D'Andrade, Org. Electron. 6, 11-20 (2005)), e* is the elemental charge. Conversion factors for recalculation of the electrochemical potentials in the case other reference electrodes or other reference redox pairs are known (see A.J. Bard, L.R. Faulkner, "Electrochemical Methods: Fundamentals and Applications", Wiley, 2. Ausgabe 2000). The information about the influence of the solution used can be found in N.G. Connelly et al., Chem. Rev. 96, 877 (1996). It is usual, even if not exactly correct, to use the terms "energy of the HOMO" E_{(HOMO)} and "energy of the LUMO" E_{(LUMO)}, respectively, as synonyms for the ionization energy and electron affinity (Koopmans Theorem). It has to be taken into consideration that the ionization potentials and the electron affinities are usually reported in such a way that a larger value represents a stronger binding of a released or of an absorbed electron, respectively. The energy scale of the frontier molecular orbitals (HOMO, LUMO) is opposed to this. Therefore, in a rough approximation, the following equations are valid: IP = -E_{(HOMO)} and EA = E_{(LUMO)} (the zero energy is assigned to the vacuum).

For the chosen reference compounds, the inventors obtained following values of the reduction potential by standardized cyclic voltammetry in tetrahydrofuran (THF) solution vs. Fc⁺/Fc: 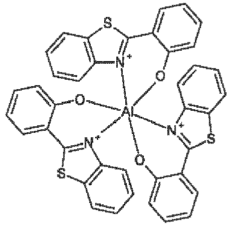 tris(2-benzo[d]thiazol-2-yl)phenoxyaluminum, CAS 1269508-14-6, -2.21 V, B0; 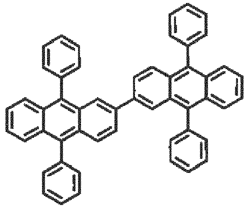 9,9',10,10'-tetraphenyl-2,2'-bianthracene (TPBA), CAS 172285-72-2, -2.28 V, B1; 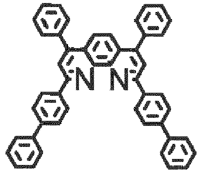 2,9-di([1,1'-biphenyl]-4-yl)-4,7-diphenyl-1,10-phenanthroline, CAS 338734-83-1, -2.29 V, B2; 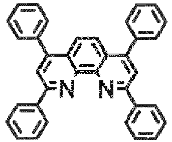 2,4,7,9-tetraphenyl-1,10-phenanthroline, CAS 51786-73-3, -2.33 V, B3; 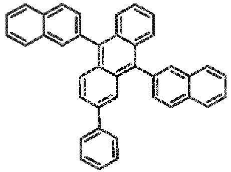 9,10-di(naphthalen-2-yl)-2-phenylanthracene (PADN), CAS 865435-20-7, -2.37 V, B4; 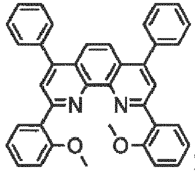 2,9-bis(2-methoxyphenyl)-4,7-diphenyl-1,10-phenanthroline, CAS 553677-79-5, -2.40 V, B5; 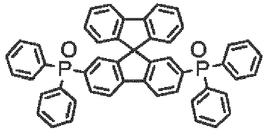 9,9'-spirobi[fluorene]-2,7-diylbis(diphenylphosphine oxide) (SPPO13), CAS 1234510-13-4, -2.41 V, B6; 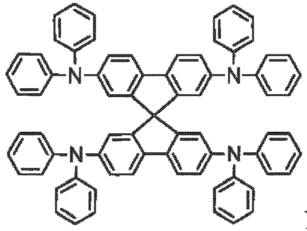 N2,N2,N2',N2',N7,N7,N7',N7'-octaphenyl-9,9'-spirobi[fluorene]-2,2',7,7'-tetraamine (Spiro TAD), CAS 189363-47-1, -3.10 V, B7; 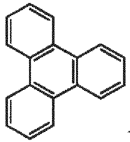 triphenylene, CAS 217-59-4, -3.04 V. B8; 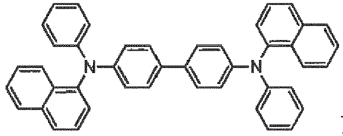 N4,N4'-di(naphthalen-1-yl)-N4,N4'-diphenyl-[1,1'-biphenyl]-4,4'-diamine (alpha-NPD), CAS 123847-85-8, -2.96 V, B9; 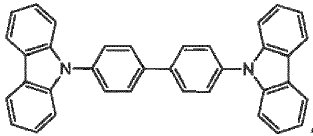 4,4'-di(9H-carbazol-9-yl)-1,1'-biphenyl (CBP), CAS 58328-31-7, -2.91 V, B10; 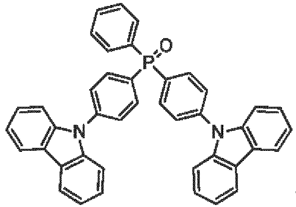 bis(4-(9H-carbazol-9-yl)phenyl)(phenyl)phosphine oxide (BCPO), CAS 1233407-28-7, -2.86, B11; 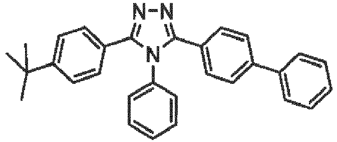 3-([1,1'-biphenyl]-4-yl)-5-(4-(tert-butyl)phenyl)-4-phenyl-4H-1,2,4-triazole (TAZ), -2.76 V, B12; 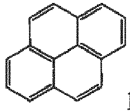 pyrene, CAS 129-00-0, -2.64 V, B13.

Examples of matrix compounds for the inventive electrically doped semiconducting materials are 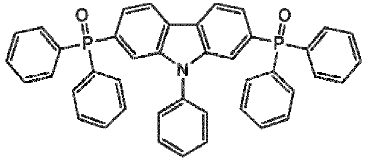 (9-phenyl-9H-carbazole-2,7-diyl)bis(diphenylphosphine oxide) (PPO27), CAS 1299463-56-1, -2.51 V, E1; 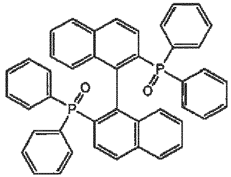 [1,1'-Binaphthalen]-2,2'-diylbis(diphenylphosphine oxide) (BINAPO), - 2.69 V, E2; 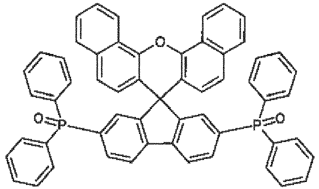 spiro[dibenzo[c,h]xanthene-7,9'-fluorene]-2',7-diylbis(diphenylphosphine oxide), -2.36 V, E3; 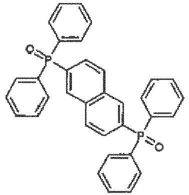 naphtalene-2,6-diylbis(diphenylphosphine oxide), -2.41 V. E4; 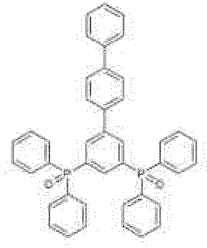 [1,1': 4',1"-terphenyl]-3,5-diylbis(diphenylphosphine oxide), -2.58 V, E5; 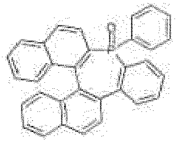 3-phenyl-3H-benzo[b]dinaphto[2,1-d:1',2'-f]phosphepine-3-oxide, CAS 597578-38-6, -2.62 V. E6: 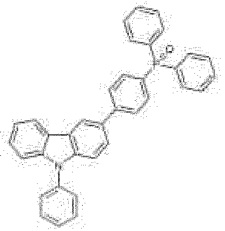 diphenyl(4-(9-phenyl-9H-carbazol-3-yl)phenylphosphine oxide, -2.81 V, E7: 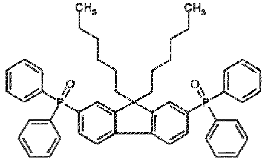 (9,9-dihexyl-9H-fluorene-2,7-diyl)bis(diphenylphosphine oxide), -2.52 V, E8; 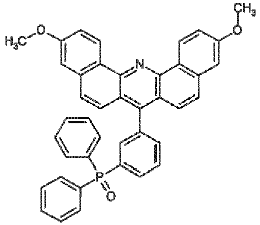 (3-(3,11-dimethoxydibenzo[c,h]acridin-7-yl)phenyl)diphenylphosphine oxide (described in WO2013/079217 A1), -2.29 V, E9; 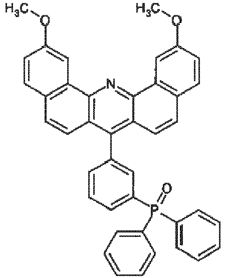 (3-(2,12-dimethoxydibenzo[c,h]acridin-7-yl)phenyl)diphenylphosphine oxide (described in WO2013/079217 A1), -2.24 V, E10; 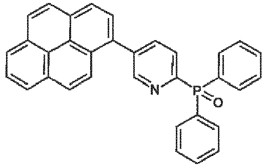 diphenyl(5-(pyren-1-yl)pyridine-2-yl)phosphine oxide, described in PCT/EP2014/057193, -2.34 V, E11;
Preferred matrix compounds for semiconducting materials of present invention are compounds E1, E2, E5, E6, E8.

As comparative compounds were used 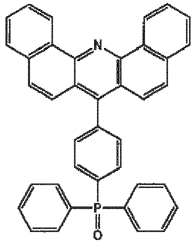 (4-(dibenzo[c,h]acridin-7-yl)phenyl)diphenylphosphine oxide (described in WO2011/154131 A1), -2.20 V, C1;
and 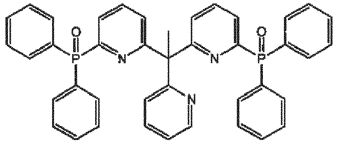 (6,6'-(1-(pyridin-2-yl)ethane-1,1-diyl)bis(pyridine-6,2-diyl))bis(diphenylphosphine oxide), described in EP 2 452 946, -2.21 V, C2; 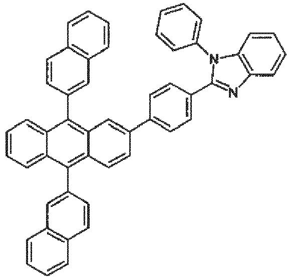 2-(4-(9,10-di(naphthalen-2-yl)anthracen-2-yl)phenyl)-1-phenyl-1H-benzo[d]imidazole, CAS 561064-11-7, -2.32 V, C3; 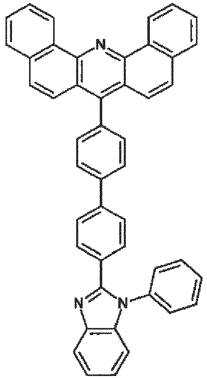 7-(4'-(1-phenyl-1H-benzo[d]imidazol-2-yl-[1,1'-biphenyl]-4-yl)dibenzo[c,h]acridine (described in WO2011/154131 A1), -2.24 V, C4; 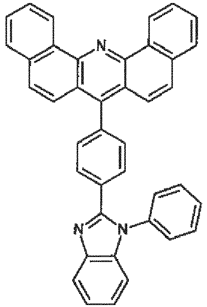 7-(4'-(1-phenyl-1H-benzo[d]imidazol-2-yl)phenyl)dibenzo[c,h]acridine (described in WO2011/154131 A1), -2.22 V, C5; 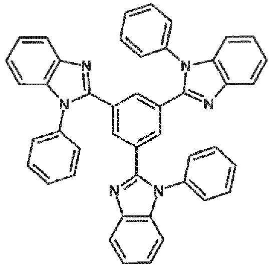 1,3,5-tris(1-phenyl-1H-benzimidazol-2-yl)benzene (TPBI) CAS 192198-85-9, -2.58 V, C6; 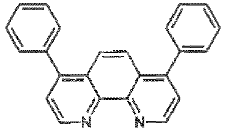 4,7-diphenyl-1,10-phenanthroline (Bphen) CAS 1662-01-7, - 2.47 V, C7; 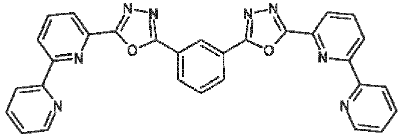 1,3-bis[2-(2,2'-bipyridine-6-yl)-1,3,4-oxadiazol-5-yl]benzene (Bpy-OXD), -2.28 V, C8; 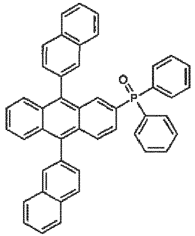 (9,10-di(naphthalen-2-yl)anthracen-2-yl)diphenylphosphine oxide, CAS 1416242-45-9, -2.19 V, C9; 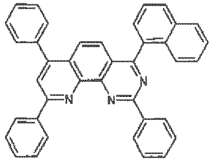 4-(naphtalen-1-yl)-2,7,9-triphenylpyrido[3,2-h]quinazoline, according to EP 1 971 371, -2.18 V, C10.

### Substrate

It can be flexible or rigid, transparent, opaque, reflective, or translucent. The substrate should be transparent or translucent if the light generated by the OLED is to be transmitted through the substrate (bottom emitting). The substrate may be opaque if the light generated by the OLED is to be emitted in the direction opposite of the substrate, the so called top-emitting type. The OLED can also be transparent. The substrate can be either arranged adjacent to the cathode or anode.

### Electrodes

The electrodes are the anode and the cathode, they must provide a certain amount of conductivity, being preferentially conductors. Preferentially the "first electrode" is the cathode. At least one of the electrodes must be semi-transparent or transparent to enable the light transmission to the outside of the device. Typical electrodes are layers or a stack of layer, comprising metal and/or transparent conductive oxide. Other possible electrodes are made of thin busbars (e.g. a thin metal grid) wherein the space between the busbars is filled (coated) with a transparent material having certain conductivity, such as graphene, carbon nanotubes, doped organic semiconductors, etc.

In one embodiment, the anode is the electrode closest to the substrate, which is called non-inverted structure. In another mode, the cathode is the electrode closest to the substrate, which is called inverted structure.

Typical materials for the Anode are ITO and Ag. Typical materials for the cathode are Mg:Ag (10 vol.% of Mg), Ag, ITO, Al. Mixtures and multilayer are also possible.

Preferably, the cathode comprises a metal selected from Ag, Al, Mg, Ba, Ca, Yb, In, Zn, Sn, Sm, Bi, Eu, Li, more preferably from Al, Mg, Ca, Ba and even more preferably selected from Al or Mg. Preferred is also a cathode comprising an alloy of Mg and Ag.

It is one of the advantages of the present invention that it allows broad selection of cathode materials, besides metals with low work function also other metals or conductive metal oxides may be used as cathode materials. It is equally well possible that the cathode is pre-formed on a substrate (then the device is an inverted device), or the cathode in a non-inverted device is formed by vacuum deposition of a metal or by sputtering.

### Hole-Transporting Layer (HTL)

The HTL is a layer comprising a large gap semiconductor responsible to transport holes from the anode or holes from a CGL to the light emitting layer (LEL). The HTL is comprised between the anode and the LEL or between the hole generating side of a CGL and the LEL. The HTL can be mixed with another material, for example a p-dopant, in which case it is said the HTL is p-doped. The HTL can be comprised by several layers, which can have different compositions. P-doping of the HTL lowers its resistivity and avoids the respective power loss due to the otherwise high resistivity of the undoped semiconductor. The doped HTL can also be used as optical spacer, because it can be made very thick, up to 1000 nm or more without significant increase in resistivity.

Suitable hole transport matrices (HTM) can be, for instance compounds from the diamine class, where a delocalized pi-electron system conjugated with lone electron pairs on the nitrogen atoms is provided at least between the two nitrogen atoms of the diamine molecule. Examples are N4,N4'-di(naphthalen-1-yl)-N4,N4'-diphenyl-[1,1'-biphenyl]-4,4'-diamine (HTM1), N4,N4, N4",N4"-tetra([1,1'-biphenyl]-4-yl)-[1,1':4',1"-terphenyl]-4,4"-diamine (HTM2). The synthesis of diamines is well described in literature; many diamine HTMs are readily commercially available.

### Hole-Injecting Layer (HIL)

The HIL is a layer which facilitates the injection of holes from the anode or from the hole generating side of a CGL into an adjacent HTL. Typically, the HIL is a very thin layer (<10 nm). The hole injection layer can be a pure layer of p-dopant and can be about 1 nm thick. When the HTL is doped, an HIL may not be necessary, since the injection function is already provided by the HTL.

### Light-Emitting Layer (LEL)

The light emitting layer must comprise at least one emission material and can optionally comprise additional layers. If the LEL comprises a mixture of two or more materials the charge carrier injection can occur in different materials for instance in a material which is not the emitter, or the charge carrier injection can also occur directly into the emitter. Many different energy transfer processes can occur inside the LEL or adjacent LELs leading to different types of emission. For instance excitons can be formed in a host material and then be transferred as singlet or triplet excitons to an emitter material which can be singlet or triplet emitter which then emits light. A mixture of different types of emitter can be provided for higher efficiency. White light can be realized by using emission from an emitter host and an emitter dopant. In one of preferred embodiments of the invention, the light emitting layer comprises at least one polymer.

Blocking layers can be used to improve the confinement of charge carriers in the LEL, these blocking layers are further explained in US 7,074,500 B2.

### Electron-Transporting Layer (ETL)

The ETL is a layer comprising a large gap semiconductor responsible for electron transport from the cathode or electrons from a CGL or EIL (see below) to the LEL. The ETL is comprised between the cathode and the LEL or between the electron generating side of a CGL and the LEL. The ETL can be mixed with an electrical n-dopant, in which case it is said the ETL is n-doped. The ETL can be comprised by several layers, which can have different compositions. Electrical n-doping the ETL lowers its resistivity and/or improves its ability to inject electrons into an adjacent layer and avoids the respective power loss due to the otherwise high resistivity (and/or bad injection ability) of the undoped semiconductor. If the used electrical doping creates new charge carriers in the extent that substantially increases conductivity of the doped semiconducting material in comparison with the undoped ETM, then the doped ETL can also be used as optical spacer, because it can be made very thick, up to 1000 nm or more without significant increase in the operational voltage of the device comprising such doped ETL. The preferable mode of electrical doping that is supposed to create new charge carriers is so called redox doping. In case of n-doping, the redox doping corresponds to the transfer of an electron from the dopant to a matrix molecule.

In case of electrical n-doping with metals used as dopants in their substantially elemental form, it is supposed that the electron transfer from the metal atom to the matrix molecule results in a metal cation and an anion radical of the matrix molecule. Hopping of the single electron from the anion radical to an adjacent neutral matrix molecule is the currently supposed mechanism of charge transport in redox n-doped semiconductors.

It is, however, hard to understand all properties of semiconductors n-doped with metals and, specifically, of semiconducting materials of present invention, in terms of electrical redox doping. It is therefore supposed that semiconducting materials of present invention advantageously combine redox doping with yet unknown favourable effects of mixing ETMs with metal atoms and/or their clusters. It is supposed that semiconducting materials of present invention contain a significant part of the added metallic element in its substantially elemental form. The term "substantially elemental" shall be understood as a form that is, in terms of electronic states and their energies, closer to the state of a free atom or to the state of a cluster of metal atoms than to the state of a metal cation or to the state of a positively charged cluster of metal atoms.

Without being limited by theory, it can be supposed that there is an important difference between the n-doped organic semiconducting materials of previous art and the n-doped semiconducting materials of the present invention. The strong redox n-dopants like alkali metals or W₂(hpp)₄ of previous art are supposed to create in common organic ETMs (having reduction potentials roughly in the range between -2.0 and -3.0 V vs. Fc⁺/Fc) the amounts of charge carriers that are commensurate to the number of individual atoms or molecules of the added dopant, and there is indeed an experience that increasing the amount of such strong dopant in the chosen matrix above certain level does not bring any substantial gain in electrical properties of the doped material.

On the other hand, the weaker dopants of the present invention behave quite different in matrices comprising phosphine oxide groups, especially in those having deeper LUMO levels in the absolute scale, corresponding to the reduction potentials vs. Fc⁺/Fc roughly in the range between -2.3 and -2.8 V. They seem to work partially also by "classical" redox mechanism improving the amount of free charge carriers, but in a manner that is less tightly linked with the dopant amount.

In other words, it is supposed that in ETMs with deeper LUMO that are specially appropriate for white or blue OLEDs, due their reduction potentials vs. Fc⁺/Fc roughly in the range between -2.3 and -2.8 V, only part of added atoms of the metallic element added as the n-dopant reacts with matrix molecules by the redox mechanism under formation of corresponding metal cations. It is rather supposed that even in high dilution, when the amount of the matrix is substantially higher than the amount of added metallic element, a substantial part of the metallic element is present in a substantially elemental form. It is further supposed that if the metallic element of the present invention is mixed with matrix of the present invention in a comparable amount, the majority of the added metallic element is present in the resulting doped semiconducting material in the substantially elemental form. This hypothesis seems to provide a reasonable explanation as to why the metallic elements of the present invention can be effectively used in significantly broader range of ratios to the doped matrix than the stronger dopants of previous art, even though they are weaker dopants. The applicable content of the metallic element in the doped semiconducting material of the present invention is roughly in the range from 0.5 weight % up to 25 weight %, preferably in the range from 1 to 20 weight %, more preferably in the range from 2 to 15 weight %, most preferably in the range from 3 to 10 weight %. Despite measurement of optical properties of the thin layers used in present OLEDs and their changes caused by doping is a challenging task having many technical obstacles, the ellipsometric measurements performed by authors seem to support the hypothesis presented above. In comparison with ETMs doped with strongly reducing alkali metals, like Li, metal complexes like W₂(hpp)₄ or with in situ generated strongly reducing radicals of WO2007/107306, the doped layers comprising semiconducting material of present invention show lower optical absorption, particularly at high dopant amounts. Quite surprisingly, the same seems to apply also for typically trivalent metals like Al that was found to perform poorly in ETMs comprising at least one phosphine oxide group, despite its ionization potentials being comparable to metallic elements useful as dopants in the present invention. It seems rather likely that favourable effects observed in phosphine oxide ETMs doped with metallic elements of the present invention are to be assigned to a yet unknown interaction of the phosphine oxide group with divalent metals, which is either impossible or significantly weaker in metals that are not able to form stable compounds in oxidation state two.

Hole blocking layers and electron blocking layers can be employed as usual.

In one mode of the invention the ETL comprises 2 zones, the first zone which is closer to LEL and the second zone which is closer to the cathode. In one of preferred embodiments, the first zone comprises a first ETM and the second zone a second ETM. More preferably, the LUMO level of the first ETM is, in comparison with the LUMO level of the second ETM, closer to the LUMO level of the emitter host that forms basis of the LEL. Also preferably, the first zone comprises only the ETM and is not electrically doped. In another preferred embodiment, the second zone comprises, besides the metallic element that acts as the first electrical dopant, also a second electrical dopant. More preferably, the second electrical dopant is a metal salt comprising at least one anion and at least one cation. In another embodiment, a metal salt is comprised in both first and second zones. In yet another embodiment, the metal salt is preferably comprised in the first zone, whereas the metallic element is preferably comprised in the second zone. In a preferred embodiment, the first and second zone are adjacent each other. Also preferably, the first zone is adjacent to the LEL. Also preferably, the first zone may be adjacent to the cathode.

Optionally, both the first and second zones comprise the same ETM.

Other layers with different functions can be included, and the device architecture can be adapted as known by the skilled in the art. For example, an Electron-Injecting Layer (EIL) made of metal, metal complex or metal salt can be used between the cathode and the ETL. Charge generation layer (CGL)

The OLED can comprise a CGL which can be used in conjunction with an electrode as inversion contact, or as connecting unit in stacked OLEDs. A CGL can have the most different configurations and names, examples are pn-junction, connecting unit, tunnel junction, etc. Best examples are pn-junctions as disclosed in US 2009/0045728 A1, US 2010/0288362 A1. Metal layers and or insulating layers can also be used.

### Stacked OLEDs

When the OLED comprises two or more LELs separated by CGLs, the OLED is called a stacked OLED, otherwise it is called a single unit OLED. The group of layers between two closest CGLs or between one of the electrodes and the closest CGL is called a electroluminescent unit (ELU). Therefore a stacked OLED can be described as anode/ELU₁/{CGL_{X}/ELU_{1+X}}_{X}/cathode, wherein x is a positive integer and each CGL_{X} or each ELU_{1+X} can be equal or different. The CGL can also be formed by the adjacent layers of two ELUs as disclosed in US2009/0009072 A1. Further stacked OLEDs are described e.g. in US 2009/0045728 A1, US 2010/0288362 A1, and references therein.

### Deposition of Organic Layers

Any organic semiconducting layers of the inventive display can be deposited by known techniques, such as vacuum thermal evaporation (VTE), organic vapour phase deposition, laser induced thermal transfer, spin coating, blade coating, slot dye coating, inkjet printing, etc. A preferred method for preparing the OLED according to the invention is vacuum thermal evaporation. Polymeric materials are preferably processed by coating techniques from solutions in appropriate solvents.

Preferably, the ETL is formed by evaporation. When using an additional material in the ETL, it is preferred that the ETL is formed by co-evaporation of the electron transporting matrix (ETM) and the additional material. The additional material may be mixed homogeneously in the ETL. In one mode of the invention, the additional material has a concentration variation in the ETL, wherein the concentration changes in the direction of the thickness of the stack of layers. It is also foreseen that the ETL is structured in sub-layers, wherein some but not all of these sub-layers comprise the additional material.

### Electrical doping

The present invention can be used in addition to or in combination with electrical doping of organic semiconducting layers.

The most reliable and, at the same time, efficient OLEDs are OLEDs comprising electrically doped layers. Generally, the electrical doping means improving of electrical properties, especially the conductivity and/or injection ability of a doped layer in comparison with neat charge-transporting matrix without a dopant. In the narrower sense, which is usually called redox doping or charge transfer doping, hole transport layers are doped with a suitable acceptor material (p-doping) or electron transport layers with a donor material (n-doping), respectively. Through redox doping, the density of charge carriers in organic solids (and therefore the conductivity) can be increased substantially. In other words, the redox doping increases the density of charge carriers of a semiconducting matrix in comparison with the charge carrier density of the undoped matrix. The use of doped charge-carrier transport layers (p-doping of the hole transport layer by admixture of acceptor-like molecules, n-doping of the electron transport layer by admixture of donor-like molecules) in organic light-emitting diodes is, e.g., described in US 2008/203406 and US 5,093,698.

US2008227979 discloses in detail the charge-transfer doping of organic transport materials, with inorganic and with organic dopants. Basically, an effective electron transfer occurs from the dopant to the matrix increasing the Fermi level of the matrix. For an efficient transfer in a p-doping case, the LUMO energy level of the dopant is preferably more negative than the HOMO energy level of the matrix or at least not more than slightly more positive, preferably not more than 0.5 eV more positive than the HOMO energy level of the matrix. For the n-doping case, the HOMO energy level of the dopant is preferably more positive than the LUMO energy level of the matrix or at least not more than slightly more negative, preferably not more than 0.5 eV lower compared to the LUMO energy level of the matrix. It is furthermore desired that the energy level difference for energy transfer from dopant to matrix is smaller than + 0.3 eV.

Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalene-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). All p-doping in the device examples of the present application was done with 3 mol% of PD2.

Typical examples of known redox doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis (1,3,4,6,7,8 - hexahydro - 2H - pyrimido [1,2 - a] pyrimidinato) ditung-sten (II) (W₂(hpp)₄); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF).

In the present invention, it was surprisingly found that classical redox dopants with high reduction strength, expressed as a highly negative redox potential measured by cyclic voltammetry (CV) in THF vs. Fc+/Fc standard, are not necessarily the best n-dopants in organic electron transport matrices. Specifically, it was surprisingly found that in ETMs bearing at least one phosphine oxide group, divalent metals are superior as n-dopants over alkali metals or organic metal complexes like W₂(hpp)₄, despite their electrochemical redox potentials are significantly less negative in comparison with alkali metals or complexes like W₂(hpp)₄. Even more surprisingly, it was found that the advantage of divalent metals is more pronounced in ETMs having their redox potentials more negative than about -2.25 V vs Fc⁺/Fc.

Besides the redox dopants, certain metal salts can be alternatively used for electrical n-doping resulting in lowering operational voltage in devices comprising the doped layers in comparison with the same device without metal salt. True mechanism how these metal salts, sometimes called "electrically doping additives", contribute to the lowering of the voltage in electronic devices, is not yet known. It is believed that they change potential barriers on the interfaces between adjacent layers rather than conductivities of the doped layers, because their positive effect on operational voltages is achieved only if layers doped with these additives are very thin. Usually, the electrically undoped or additive doped layers are thinner than 50 nm, preferably thinner than 40 nm, more preferably thinner than 30 nm, even more preferably thinner than 20 nm, most preferably thinner than 15 nm. If the manufacturing process is precise enough, the additive doped layers can be advantageously made thinner than 10 nm or even thinner than 5 nm.

Typical representatives of metal salts which are effective as second electrical dopants in the present invention are salts comprising metal cations bearing one or two elementary charges. Favourably, salts of alkali metals or alkali earth metals are used. The anion of the salt is preferably an anion providing the salt with sufficient volatility, allowing its deposition under high vacuum conditions, especially in the temperature and pressure range which is comparable with the temperature and pressure range suitable for the deposition of the electron transporting matrix.

Example of such anion is 8-hydroxyquinolinolate anion. Its metal salts, for example lithium 8-hydroxyquinolinolate (LiQ) represented by the formula D1 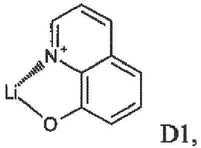 are well known as electrically doping additives.

Another class of metal salts useful as electrical dopants in electron transporting matrices of the present invention represent compounds disclosed in the application PCT/EP2012/074127, having general formula (II) 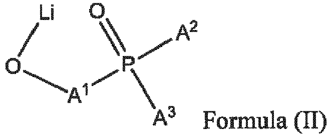 wherein A¹ is a C₆-C₂₀ arylene and each of A²-A³ is independently selected from a C₆-C₂₀ aryl, wherein the aryl or arylene may be unsubstituted or substituted with groups comprising C and H or with a further LiO group, provided that the given C count in an aryl or arylene group includes also all substituents present on the said group. It is to be understood that the term substituted or unsubstituted arylene stands for a divalent radical derived from substituted or unsubstituted arene, wherein the both adjacent structural moieties (in formula (I), the OLi group and the diaryl prosphine oxide group) are attached directly to an aromatic ring of the arylene group. In examples of the present application, this class of dopants is represented by compound D2 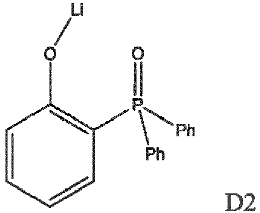 wherein Ph is phenyl.

Yet another class of metal salts useful as electrical dopants in electron transporting matrices of the present invention represent compounds disclosed in the application PCT/EP2012/074125, having general formula (III) 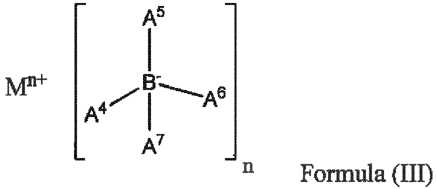 wherein M is a metal ion, each of A⁴- A⁷ is independently selected from H, substituted or unsubstituted C₆-C₂₀ aryl and substituted or unsubstituted C₂-C₂₀ heteroaryl and n is valency of the metal ion. In examples of the present application, this class of dopants is represented by compound D3

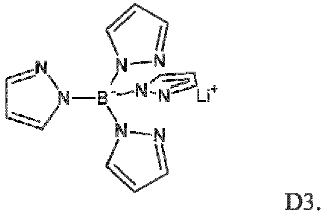

### V. ADVANTAGEOUS EFFECT OF THE INVENTION

The favourable effects of the inventive electrically doped semiconducting materials are shown in comparison with comparative devices comprising instead of the inventive combination of electron transporting matrices and dopants other combinations of matrices and dopants known in the art. The used devices are described in detail in examples.

In the first screening phase, there were in device of example 1 tested 32 matrix compounds with 5 wt.% Mg as dopant. Electron transport matrices comprising phosphine oxide matrices and having their LUMO level expressed in terms of their reduction potential vs. Fc⁺/Fc (measured by cyclic voltammetry in THF) higher than compound D0 (-2.21 V under standardized conditions used) performed better than C1 and C2, in terms of operational voltage and/or quantum efficiency of the device, and significantly better than matrices lacking the phosphine oxide group, irrespective of their LUMO level. These observations were confirmed also for several other divalent metals, namely Ca, Sr, Ba, Sm and Yb. The results are summarized in Table 1, wherein relative change of voltage and efficiency (both measured at current density 10 mA/cm²) is calculated against the C2/Mg system of previous art taken as the reference. The overall score is calculated by subtraction of relative voltage change from relative change of efficiency.

**Table 1a**

| ETL matrix | ETL dopant | wt% dopant | U (V) | (U-U_{ref})/U_{ref} (%) | EQE (%) | (EQE-EQE_{ref}/EQE_{ref} (%) | score |
|---|---|---|---|---|---|---|---|
| E1 | Mg | 5 | 3.2 | -40 | 5.15 | -9 | +31 |
| E1 | Ca | 1 | 3.497 | -35 | 5.415 | -4 | +31 |
| E1 | Ca | 5 | 3.633 | -32 | 5.235 | -7 | +25 |
| E1 | Ba | 1 | 3.577 | -33 | 6.090 | +8 | +41 |
| E1 | Ba | 5 | 3.491 | -35 | 5.560 | -1 | +34 |
| E2 | Mg | 5 | 3.56 | -34 | 5.33 | -5 | +29 |
| E2 | Ca | 1 | 3.245 | -39 | 5.750 | +2 | +41 |
| E2 | Ca | 5 | 3.83 | -29 | 5.83 | +4 | +33 |
| E2 | Ba | 1 | 6.104 | +13 | 6.245 | +14 | +1 |
| E2 | Ba | 5 | 3.293 | -39 | 6.055 | +8 | +47 |
| E3 | Mg | 5 | 3.68 | -31 | 4.68 | -17 | +14 |
| E4 | Mg | 5 | 3.6 | -33 | 3.9 | -31 | +2 |
| E4 | Ca | 2 | 3.490 | -35 | 5.900 | +5 | +40 |
| E4 | Ba | 2 | 4.020 | -25 | 6.150 | +9 | +34 |
| E4 | Sm | 2 | 3.806 | -29 | 5.600 | 0 | +29 |
| E4 | Yb | 2 | 3.844 | -28 | 5.390 | -4 | +24 |
| E5 | Mg | 5 | 3.29 | -29 | 5.45 | -3 | +26 |
| E6 | Mg | 5 | 3.53 | -34 | 7.73 | +38 | +72 |
| E6 | Ca | 2 | 3.350 | -37 | 5.650 | +0 | +37 |
| E6 | Ba | 2 | 3.710 | -31 | 6.320 | +12 | +43 |
| E6 | Sm | 2 | 3.429 | -36 | 6.040 | +7 | +43 |
| E6 | Yb | 2 | 3.427 | -36 | 5.965 | +6 | +42 |
| E7 | Mg | 5 | 5.2 | -3 | 6.48 | +15 | +18 |
| E8 | Mg | 5 | 3.36 | -37 | 5.6 | 0 | +37 |
| E8 | Ca | 2 | 3.26 | -39 | 5.24 | -7 | +32 |
| E8 | Ba | 2 | 3.329 | -38 | 5.990 | +6 | +44 |
| E9 | Mg | 5 | 4.51 | -16 | 7.5 | +33 | +49 |
| E10 | Mg | 5 | 3.81 | -29 | 4.7 | -17 | +12 |
| E11 | Mg | 5 | 3.88 | -28 | 4.53 | -20 | +8 |
| E11 | Sr | 1 | 3.642 | -32 | 5.500 | -2 | +30 |
| E11 | Sr | 3 | 3.653 | -32 | 5.075 | -10 | +22 |
| E11 | Sm | 2 | 4.113 | -23 | 5.365 | -5 | +18 |
| E11 | Sm | 5 | 4.067 | -24 | 4.435 | -21 | +3 |
| E11 | Yb | 2 | 3.693 | -31 | 5.485 | -3 | +28 |
| E11 | Yb | 5 | 3.796 | -29 | 5.105 | -9 | +20 |

**Table 1b (continuation of Table 1a)**

| ETL matrix | ETL dopant | wt% dopant | U (V) | (U-U_{ref}/U_{ref} (%) | EQE (%) | (EQE-EQE_{ref}/EQE_{ref} (%) | score |
|---|---|---|---|---|---|---|---|
| B6 | Mg | 5 | 3.44 | -36 | 4.00 | -29 | +7 |
| B2 | Mg | 5 | 5.67 | +5 | 0.66 | -89 | -94 |
| B4 | Ca | 2 | 7.549 | +40 | 0.49 | -92 | -132 |
| B4 | Ba | 2 | 9.784 | +82 | 2.260 | -60 | -142 |
| B4 | Sm | 2 | 7.993 | +48 | 1.400 | -75 | -123 |
| B4 | Yb | 2 | 8.689 | +65 | 1.960 | -65 | -130 |
| C1 | Mg | 5 | 4.2 | -22 | 2.6 | -54 | -32 |
| C2 | Mg | 5 | 5.4 | 0 | 5.6 | 0 | 0 |
| C3 | Mg | 5 | 7.11 | +32 | 0.85 | -85 | -117 |
| C4 | Mg | 5 | 8.3 | +54 | 2.32 | -59 | -114 |
| C5 | Mg | 5 | 6.8 | +26 | 2.9 | -49 | -75 |
| C6 | Mg | 5 | 8.78 | +63 | 3.78 | -33 | -96 |
| C6 | Ca | 2 | 5.500 | +2 | 4.045 | -28 | -30 |
| C6 | Ba | 2 | 7.101 | +32 | 3.865 | -31 | -63 |
| C6 | Sm | 2 | 8.167 | +52 | 2.355 | -58 | -110 |
| C6 | Yb | 2 | 8.130 | +51 | 3.075 | -46 | -97 |
| C7 | Mg | 5 | 4.17 | -22 | 0.9 | -84 | -62 |
| C7 | Sm | 2 | 5.362 | 0 | 1.680 | -70 | -70 |
| C7 | Yb | 2 | 5.866 | +9 | 1.890 | -67 | -76 |
| C8 | Mg | 5 | 4.17 | -22 | 1.04 | -82 | -60 |
| C9 | Mg | 5 | 4.2 | -22 | 1 | -83 | -61 |
| D1 | Ca | 2 | 6.731 | +25 | 2.230 | -61 | -86 |
| D1 | Ba | 2 | 8.515 | +58 | 2.295 | -60 | -118 |
| D1 | Sm | 2 | 7.972 | +48 | 2.250 | -60 | -108 |
| D1 | Yb | 2 | 8.006 | +49 | 2.765 | -51 | -100 |

In the second phase of the research, various metals were tested in device 2 in matrices E1, E2 and C1, with two different ETL thicknesses 40 nm (U₁ and U₃) and 80 nm (U₂ and U₄) and with two different doping concentrations 5 wt% (U₁ and U₂) and 25 wt.% (U₃ and U₄), all for current density 10 mA/cm².

The results summarized in Table 2 led to a surprising finding that metals that are able to form stable compounds in oxidation state II are especially appropriate for n-doping in phosphine oxide matrices despite their significantly lower reactivity and higher air stability in comparison with the least reactive alkali metal (Li). From the divalent metals tested, only zinc having extremely high sum of the first and second ionization potential failed as n-dopant, whereas aluminium with typical oxidation state III gave reasonably low operational voltages only if present in the doped ETL in the high 25 wt.% concentration that afforded ETLs with impractically high light absorption. Transmittance assigned as "OD" that stands for "optical density" is reported in Table 2 only for 25 wt% doping concentration (OD₃ for layer thickness 40 nm and OD₄ for layer thickness 80 nm), as the measurements for lower doping concentrations suffered from bad reproducibility.

The typically trivalent bismuth failed as n-dopant completely, despite its ionization potential does not differ much, e.g. from manganese, that showed, quite surprisingly, good doping action at least in E1.

Low values of differences U₁-U₂ and U₃-U₄ can be assigned to doped materials having high conductivity (voltage of the device depends only weakly on the thickness of the doped layer).

**Table 2a**

| ETL matrix | ETL dopant | U₁ (V) | U₂ (V) | U₁-U₂ (V) | U₃ (V) | U₄ (V) | U₃-U₄ (V) | OD₃ | OD₄ |
|---|---|---|---|---|---|---|---|---|---|
| E₁ | Li | 9.042 | >10 | na | 5.814 | 6.666 | 0.853 | 38 | 43 |
| E₁ | Na | 2.863 | 2.864 | 0.001 | 5.354 | 7.186 | 1.832 | 70 | 64 |
| E₁ | Mg | 2.954 | 2.970 | 0.016 | 2.965 | 2.960 | 0.005 | 62 | 33 |
| E₁ | Ca | 4.625 | 4.340 | -0.286 | 5.590 | 9.081 | 3.491 | 63 | 52 |
| E₁ | Sr | 3.650 | 3.700 | 0.050 | - | - | - | - | - |
| E₁ | Ba | 4.085 | 4.023 | -0.062 | 4.360 | 4.567 | 0.207 | 67 | 73 |
| E₁ | Sm | 3.138 | 3.136 | -0.002 | 7.889 | - | - | 63 | 61 |
| E₁ | Eu | - | - | - | 4.090 | 4.119 | 0.029 | - | - |
| E₁ | Yb | 3.022 | 3.032 | 0.009 | 5.578 | 6.932 | 1.354 | 66 | 68 |
| E₁ | Mn | 3.38 | 3.40 | 0.017 | - | - | - | - | - |
| E₁ | Zn | 6.124 | 8.842 | 2.718 | 5.592 | 7.545 | 1.954 | 65 | 76 |
| E₁ | Al | 7.614 | >10 | na | 3.321 | 3.301 | -0.020 | 48 | 31 |
| E₁ | Bi | 6.129 | 8.768 | 2.640 | 5.430 | 7.275 | 1.845 | 56 | 54 |
| E₂ | Li | 6.333 | 8.362 | 2.029 | 3.307 | 3.324 | 0.017 | 51 | 32 |
| E₂ | Na | 3.735 | 4.533 | 0.798 | >10 | >10 | na | 65 | 38 |
| E₂ | Mg | 3.189 | 3.232 | 0.043 | 3.464 | 3.489 | 0.025 | 68 | 72 |
| E₂ | Ca | 4.426 | 4.503 | 0.078 | 3.911 | 4.501 | 0.590 | 64 | 50 |
| E₂ | Sr | 3.842 | 3.832 | -0.010 | - | - | - | - | - |
| E₂ | Ba | 2.929 | 2.935 | 0.006 | 3.397 | 3.397 | 0.000 | 74 | 71 |
| E₂ | Sm | 3.610 | 3.894 | 0.284 | 6.053 | 7.939 | 1.887 | 72 | 63 |
| E₂ | Eu | - | - | - | 4.516 | 4.838 | 0.322 | - | - |
| E₂ | Yb | 2.932 | 2.933 | 0.001 | 5.442 | 6.625 | 1.183 | 73 | 65 |
| E₂ | Mn | 6.02 | 8.09 | 0.99 | - | - | - | - | - |
| E₂ | Zn | 7.898 | >10 | na | 7.000 | >10 | na | 66 | 71 |
| E₂ | Al | 8.650 | >10 | na | 3.203 | 3.196 | -0.007 | 39 | 27 |
| E₂ | Bi | 7.814 | >10 | na | 7.173 | >10 | na | 64 | 61 |

**Table 2b (continuation of Table 2a)**

| ETL matrix | ETL dopant | U₁ (V) | U₂ (V) | U₁-U₂ (V) | U₃ (V) | U₄ (V) | U₃-U₄ (V) | OD₃ | OD₄ |
|---|---|---|---|---|---|---|---|---|---|
| C1 | Li | 6.997 | >10 | na | 6.209 | 8.314 | 2.105 | 72 | 48 |
| C1 | Na | - | - | - | 4.417 | 4.455 | 0.037 | 56 | 31 |
| C1 | Mg | 4.180 | 4.178 | -0.002 | 4.174 | 4.167 | -0.007 | 62 | 57 |
| C1 | Ca | 4.031 | 4.104 | 0.074 | 3.619 | 3.616 | -0.004 | 38 | 21 |
| C1 | Sr | 4.033 | 4.071 | 0.0038 | - | - | - | - | - |
| C1 | Ba | 3.916 | 3.909 | -0.006 | 3.969 | 4.605 | 0.636 | 63 | 39 |
| C1 | Sm | 4.208 | 4.207 | 0.000 | 4.106 | 4.104 | -0.002 | 63 | 48 |
| C1 | Eu | 3.972 | 3.984 | 0.012 | - | - | - | - | - |
| C1 | Yb | 4.017 | 4.167 | -0.003 | 4.148 | 4.173 | 0.025 | 33 | 29 |
| C1 | Mn | 4.27 | 4.26 | -0.01 | - | - | - | - | - |
| C1 | Zn | 5.084 | 7.758 | 2.674 | 4.699 | 6.402 | 1.703 | 57 | 50 |
| C1 | Al | 4.152 | 4.949 | 0.797 | 3.135 | 3.123 | -0.011 | 45 | 26 |
| C1 | Bi | 4.842 | 6.355 | 1.513 | 4.306 | 4.603 | 0.297 | 59 | 68 |

In matrices with deep LUMO, like C1, the operational voltage is often surprisingly higher than in devices comprising matrices with the LUMO levels in the range according to invention, despite good conductivity of many doped semiconducting materials based on C1. Apparently, the good conductivity of a semiconducting material is not a sufficient condition for low operational voltage of the device comprising it. Based on this finding, it is supposed that doped semiconducting materials according to this invention enable, besides the reasonable conductivity, also efficient charge injection from the doped layer in the adjacent layer.

In the third research phase, the observed effects were confirmed in OLEDs of example 3 comprising alternative emitter systems and further embodiments of the invention described in examples 4- 7 were implemented. The achieved results summarized in Table 3 confirmed the surprising superiority of phosphine oxide ETL matrices having higher LUMO levels, despite these matrices should be more difficult to dope with the relatively weakly reducing metals used in the present invention in comparison with the phosphine oxide matrices of the previous art (like C1) which were thought to be dopable with Mg owing to their deeper LUMO and specific structure comprising the metal complexing unit.

This series of experiments confirmed that also with other emitters, the preferred matrix compounds like E1 and E2 of the present invention perform better than other phosphine oxide matrix compounds that do not fall within the scope described in the summary of invention, and much better in comparison with matrices lacking the phosphine oxide group.

The results showed that if combined with matrices defined in the summary of the invention, even substantially air stable metals, possessing moreover further technically advantageous features like good evaporability, can afford electrically doped semiconductive materials and devices that perform equally well or even better than devices available in the art.

**Table 3**

| LEL | ETL matrix | ETL dopant | wt% dopant | U (V) | (U-U_{ref})/ U_{ref} (%) | EQE (%) | (EQE-EQE_{ref})/ EQE_{ref} (%) | score |
|---|---|---|---|---|---|---|---|---|
| ABH-112/ NUBD-369 | E1 | Mg | 5 | 3.498 | -35 | 6.640 | +18 | +53 |
| | E2 | Mg | 5 | 3.751 | -30 | 5.975 | +6 | +36 |
| | C1 | Mg | 5 | 4.545 | -15 | 3.905 | -30 | -15 |
| | C10 | Mg | 5 | - | - | 0 | no light | - |
| Two - colour fluoresc. white* | E1 | Mg | 5 | 3.480 | -35 | 7.660 | +36 | +71 |
| | E2 | Mg | 5 | 3.83 | -29 | 6.67 | +19 | +48 |
| | C1 | Mg | 5 | 4.970 | -8 | 4.470 | -20 | -12 |
| | C10 | Mg | 5 | 6.950 | +28 | 0.820 | -85 | -113 |
| Spiro-Pye/ BCzVB | E1 | Mg | 5 | 3.331 | -38 | 6.19 | +10 | +48 |
| | E1 | Ca | 5 | 3.311 | -38 | 4.46 | -20 | +18 |
| | E1 | Ba | 12 | 3.087 | -42 | 3.44 | -39 | +3 |
| | E1 | Sm | 5 | 3.318 | -38 | 4.53 | -19 | +19 |
| | E2 | Mg | 5 | 3.480 | -35 | 6.08 | +8 | +43 |
| | E2 | Ca | 5 | 3.497 | -35 | 3.56 | -37 | +1 |
| | E2 | Ba | 5 | 3.090 | -42 | 3.59 | -36 | +6 |
| | C7 | Mg | 5 | 3.679 | -31 | 0.32 | -94 | -63 |
| | C7 | Ca | 5 | 3.647 | -33 | 0.52 | -90 | -57 |

| | | | | | | | | |
|---|---|---|---|---|---|---|---|---|
| * ABH-112/NUBD-369 + ABH-036/NRD129 (Sun Fine Chemicals) | | | | | | | | |

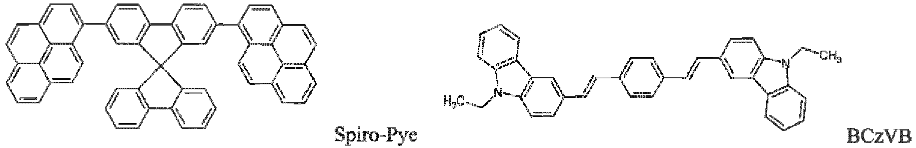

### I. EXAMPLES

### AUXILIARY MATERIALS

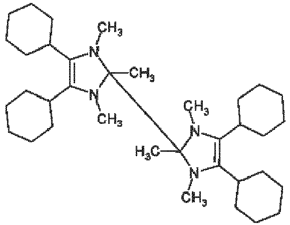

4,4',5,5'-tetracyclohexyl-1,1',2,2',3,3'-hexamethyl-2, 2', 3, 3'-tetrahydro-1H, 1'H-biimidazole, CAS 1253941-73-9, F1; 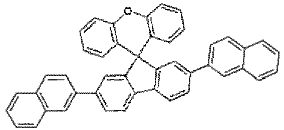 2,7-di(naphtalen-2-yl)spiro[fluorene-9,9'-xanthene], LUMO (CV vs. Fc⁺/Fc) -2.63 V, WO2013/149958, F2;

### Device examples

### Example 1 (blue OLED)

A first blue emitting device was made by depositing a 40 nm layer of HTM2 doped with PD2 (matrix to dopant weight ratio of 97:3 wt.%) onto an ITO-glass substrate, followed by a 90 nm undoped layer of HTM1. Subsequently, a blue fluorescent emitting layer of ABH113 (Sun Fine Chemicals) doped with NUBD370 (Sun Fine Chemicals) (97:3 wt%) was deposited with a thickness of 20 nm. A 36 nm layer of the tested inventive or comparative compound was deposited on the emitting layer together with the desired amount of the metallic element (usually, with 5 wt% Mg) as ETL. Subsequently, an aluminium layer with a thickness of 100 nm was deposited as a cathode.

The observed voltages and quantum efficiencies at a current density 10 mA/cm² are reported in the Table 1.

### Example 2 (organic diode)

A similar device was produced as in Example 1, with the difference that the emitter was omitted, and each combination matrix-dopant was tested in two different thicknesses of the ETL (40 and 80 nm) and with two different dopant concentrations (5 and 25 wt.%). The observed voltages at the current density 10 mA/cm² and, wherever measured, optical absorbances of the device, are reported in the Table 2.

### Example 3

A similar device was produced as in Example 1, with the difference that there were combined various compositions of the inventive and comparative semiconducting materials in the ETL with various emitter systems. The results were evaluated similarly as in Example 1 and are summarized in Table 3.

### Example 4

In device of Example 1, Al cathode was replaced with the sputtered indium tin oxide (ITO) cathode in combination with the Mg or Ba doped ETL. The results showed that the inventive technical solution is applicable also in top emitting OLEDs with cathode made of transparent semiconductive oxide.

### Example 5

In transparent devices having p-side (substrate with ITO anode, HTL, EBL) as in Example 1, and sputtered 100 nm thick ITO cathode as in Example 4, polymeric emitting layer comprising blue emitting polymer (supplied by Cambridge Display Technology) was successfully tested. The results reported in Table 4 (together with the n-side composition of the device, which in all cases comprised a 20 nm thick HBL consisting of F2 and ETL1 consisting of E2 and D3 in weight ratio 7:3 and having a thickness given in the table) show that inventive ETLs are applicable even with polymeric LELs having very high LUMO levels about -2.8 V (in terms of their redox potential vs. Fc⁺/Fc reference). Without metal doped ETL, the devices had (at current density 10 mA/cm²) very high voltages, even when EILs made of pure metal were deposited under the ITO electrode.

**Table 4**

| ETL1 (nm) | ETL2 (30 nm) | EIL | U (V) | EQE (%) | CIE1931x | CIE1931y |
|---|---|---|---|---|---|---|
| 20 | E2/Mg 8:2 | 5 nm Mg-Ag (9:1) | 4.2 | 1.6 | 0.16 | 0.11 |
| 10 | E2/Mg 9:1 | 5 nm Ba | 4.5 | 1.3 | 0.16 | 0.13 |
| 20 | E2/Mg 8:2 | 5nm Al | 5.4 | 1.1 | 0.16 | 0.14 |
| 5 | E2/Ba 8:2 | - | 4.6 | 1.3 | 0.16 | 0.18 |
| 20 | - | 5 nm Mg-Ag (9:1) | 7.5 | 1.8 | 0.17 | 0.22 |
| 10 | - | 5 nm Ba | 6.4 | 2.2 | 0.10 | 0.13 |

### Example 6

Evaporation behaviour of Mg in a linear evaporation source was tested. It was demonstrated that Mg can be deposited from linear sources with the rate as high as 1 nm/s without spitting, whereas point evaporation sources spit Mg particles at the same deposition rate significantly.

### Example 7

Mixed ETL comprising a matrix combined with LiQ + either Mg or W₂(hpp)₄ a combined two-component doping system showed the superiority of the salt + metal combination.

The features disclosed in the foregoing description, in the claims and in the accompanying drawings may both separately and in any combination be material for realizing the invention in diverse forms thereof.

**Table 5**

| Element | Iₚ^{I} eV² | Iₚ^{II} eV² | ∑Iₚ^{I-II} eV² | b.p.¹ °C | E⁰ V |
|---|---|---|---|---|---|
| Li | 5.391 | 75.640 | 81.031 | 1330 | -3.04 |
| Na | 5.139 | 47.286 | 52.425 | 890 | -2.713 |
| Mg | 7.646 | 15.035 | 22.681 | 1110 | -2.372 |
| Al | 5.986 | 18.829 | 24.815 | 2470 | -1.676 |
| Ca | 6.113 | 11.872 | 17.985 | 1487 | -2.84 |
| Mn | 7.434 | 15.640 | 23.074 | 2100 | -1.18 |
| Zn | 9.394 | 17.964 | 27.358 | 907 | -0.793 |
| Sr | 5.695 | 11.030 | 16.725 | 1380 | -2.89 |
| Ba | 5.212 | 10.004 | 15.216 | 1637 | -2.92 |
| Sm | 5.644 | 11.07 | 16.714 | 1900 | ** |
| Eu | 5.670 | 11.241 | 16.911 | 1440 | -1.99 |
| Yb | 6.254 | 12.176 | 18.430 | 1430 | -2.22 |
| Bi | 7.286 | 16.69 | 23.976 | 1560 | 0.317 |

| | | | | | |
|---|---|---|---|---|---|
| ¹Yiming Zhang, Julian R. G. Evans, Shoufeng Yang: Corrected Values for Boiling Points and Enthalpies of Vaporization of Elements in Handbooks. From: Journal of Chemical & Engineering Data. 56, 2011, p. 328-337; the values fit with values given in articles for individual elements in current German version of Wikipedia. ² http://en.wikipedia.org/wiki/Ionization energies of the elements %28data page%29 | | | | | |

### Used abbreviations

- CV: cyclic voltammetry
- UV: ultraviolet (light)
- DCM: dichloromethane
- Fc⁺/Fc: ferrocenium/ferrocene reference system
- THF: tetrahydrofuran
- vol%: volume percent
- mol%: molar percent
- wt%: weight (mass) percent
- OLED: organic light emitting diode
- VTE: vacuum thermal evaporation
- HOMO: highest occupied molecular orbital
- LUMO: lowest unoccupied molecular orbital
- ETL: electron transporting layer
- EIL: electron injecting layer
- ETM: electron transport matrix
- HTL: hole transporting layer
- HIL: hole injecting layer
- HTM: hole transport matrix
- CGL: charge generating layer
- LEL: light emitting layer
- LiQ: lithium 8-hydroxyquinolinolate
- ITO: indium tin oxide
- QA: quality assurance

## Claims

1. Electrically doped semiconducting material comprising at least one metallic element in its substantially elemental form as n-dopant and at least one electron transport matrix compound comprising at least one phosphine oxide group, wherein the metallic element is selected from elements that form in their oxidation number II at least one stable compound and the electron transport matrix compound has the reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than N4,N4'-di(naphthalen-1-yl)-N4,N4'-diphenyl-[1,1'-biphenyl]-4,4'-diamine, even more preferably higher than 4,4'-di(9H-carbazol-9-yl)-1,1'-biphenyl, most preferably higher than bis(4-(9H-carbazol-9-yl)phenyl)(phenyl)phosphine oxide, less but still preferably higher than 3-([1,1'-biphenyl]-4-yl)-5-(4-(tert-butyl)phenyl)-4-phenyl-4H-1,2,4-triazole and even less but still preferably higher than pyrene.

2. Electrically doped semiconducting material according to claim 1, wherein the electron transport matrix compound is a compound according to formula (I): 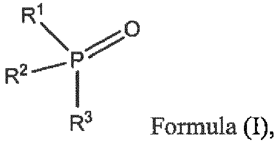 wherein R¹, R² and R³ are independently selected from C₁-C₃₀-alkyl, C₃-C₃₀-cycloalkyl, C₂-C₃₀-heteroalkyl, C₆-C₃₀-aryl, C₂-C₃₀-heteroaryl, C₁-C₃₀-alkoxy, C₃-C₃₀-cycloalkyloxy, C₆-C₃₀-aryloxy, wherein each of the substituents R¹, R² and R³ optionally comprises further phosphine oxide groups and at least one of the substituents R¹, R² and R³ comprises a conjugated system of at least 10 delocalized electrons.

3. Electrically doped semiconducting material according to claim 1 or 2, wherein the metallic element has a sum of its first and second ionization potential lower than 25 eV, preferably lower than 24 eV, more preferably lower than 23.5 eV, most preferably lower than 23.1 eV.

4. Electrically doped semiconducting material according to any of claims 2-3, wherein the conjugated system of at least 10 delocalized electrons is attached directly to the phosphine oxide group.

5. Electrically doped semiconducting material according to claim 2 or 3, wherein the conjugated system of at least 10 delocalized electrons is separated from the phosphine oxide group by a spacer group A.

6. Electrically doped semiconducting material according to claim 5, wherein the spacer group A is a divalent six-membered aromatic carbocyclic or heterocyclic group.

7. Electrically doped semiconducting material according to claim 6, wherein the spacer A is selected from phenylene, azine-2,4-diyl, azine-2,5-diyl, azine-2,6-diyl, 1,3-diazine-2,4-diyl and 1,3-diazine-2,5-diyl.

8. Electrically doped semiconducting material according to any of claims 2-7, wherein the conjugated system of at least 10 delocalized electrons is a C₁₄-C₅₀-aryl or a C₈-C₅₀ heteroaryl.

9. Electrically doped semiconducting material according to any of claims 1-8, further comprising a metal salt additive consisting of at least one metal cation and at least one anion.

10. Electrically doped semiconducting material according to claim 9, wherein the metal cation is Li⁺ or Mg²⁺.

11. Electrically doped semiconducting material according to claim 9 or 10, wherein the metal salt additive is selected from metal complexes comprising a 5-, 6- or 7-membered ring that contains a nitrogen atom and an oxygen atom attached to the metal cation and from complexes having the structure according to formula (II) 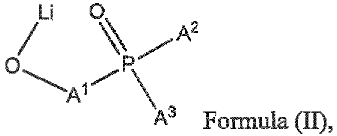 wherein A¹ is a C₆-C₃₀ arylene or C₂-C₃₀ heteroarylene comprising at least one atom selected from O, S and N in an aromatic ring and each of A² and A³ is independently selected from a C₆-C₃₀ aryl and C₂-C₃₀ heteroaryl comprising at least one atom selected from O, S and N in an aromatic ring.

12. Electrically doped semiconducting material according to any of claims 9-11, wherein the anion is selected from the group consisting of phenolate substituted with a phosphine oxide group, 8-hydroxyquinolinolate and pyrazolylborate.

13. Process for manufacturing the semiconducting material defined in any of claims 1-12, comprising a step where the electron transport matrix compound comprising at least one phosphine oxide group and the metallic element selected from elements that form in their oxidation number II at least one stable compound are coevaporated and codeposited under reduced pressure,
wherein the electron transport matrix compound has a reduction potential, when measured by cyclic voltammetry under the same conditions, lower than tris(2-benzo[d]thiazol-2-yl)phenoxyaluminum, preferably lower than 9,9',10,10'-tetraphenyl-2,2'-bianthracene or 2,9-di([1,1'-biphenyl]-4-yl)-4,7-diphenyl-1,10-phenanthroline, more preferably lower than 2,4,7,9-tetraphenyl-1,10-phenanthroline, even more preferably lower than 9,10-di(naphthalen-2-yl)-2-phenylanthracene, most preferably lower than 2,9-bis(2-methoxyphenyl)-4,7-diphenyl-1,10-phenanthroline, still preferably lower than 9,9'-spirobi[fluorene]-2,7-diylbis(diphenylphosphine oxide), and higher than N2,N2,N2',N2',N7,N7,N7',N7'-octaphenyl-9,9'-spirobi[fluorene]-2,2',7,7'-tetraamine, preferably higher than triphenylene, more preferably higher than 4,4'-di(9H-carbazol-9-yl)-1,1'-biphenyl, even more preferably higher than bis(4-(9H-carbazol-9-yl)phenyl)(phenyl)phosphine oxide, most preferably higher than 3-{[1,1'-biphenyl]-4-yl)-5-(4-(tert-butyl)phenyl)-4-phenyl-4H-1,2,4-triazole.

14. Process according to claim 13, wherein the metallic element is selected from Mg, Ca, Sr, Ba, Yb, Sm, Eu and Mn.

15. Process according to claim 13 or 14, wherein the metallic element has normal boiling point lower than 3000 °C, preferably lower than 2200 °C, more preferably lower than 1800 °C, most preferably lower than 1500°C.

16. Process according to any of claims 13-15, wherein the metallic element has a sum of its first and second ionization potential higher than 16 eV, preferably higher than 17 eV, more preferably higher than 18 eV, even more preferably higher than 20 eV, most preferably higher than 21 eV, less but still preferably higher than 22 eV and even less but still preferably higher than 23 eV.

17. Process according to any of claims 13-16, wherein the metallic element is substantially air stable.

18. Process according to any of claims 13-17, wherein the metallic element is evaporated from a linear evaporation source.

19. Electronic device comprising a cathode, an anode and the electrically doped semiconducting material according to any of claims 1-12 between the cathode and anode.

20. Electronic device according to claim 19, further comprising a light emitting layer between the cathode and anode.

21. Electronic device according to claim 19 or 20, wherein the electrically doped semiconducting material is comprised in an electron transporting or electron injecting layer.

22. Electronic device according to claim 21, wherein the electron transporting or electron injecting layer is thicker than 5 nm, preferably thicker than 10 nm, more preferably thicker than 15 nm, even more preferably thicker than 20 nm and most preferably thicker than 25 nm.

23. Electronic device according to claim 21 or 22, wherein the electron transporting layer comprises a first compartment closer to the light emitting layer and a second compartment closer to the cathode, the first and second compartment differing in their composition.

24. Electronic device according to claim 23, wherein the first compartment consists of a first electron transporting matrix.

25. Electronic device according to claim 23, wherein the first compartment comprises the first electron transporting matrix and a metal salt additive consisting of at least one metal cation and at least one anion.

26. Electronic device according to claim 25, wherein the first compartment consists of the first electron transporting matrix and the metal salt additive and the second compartment consists of the electrically doped semiconducting material according to any of claims 1-13 and 20.

27. Electronic device according to claim 26, wherein the second compartment consists of a second electron transport matrix and the metallic element in its substantially elemental form.

28. Electronic device according to any of claims 24-27, wherein the first compartment is thinner than 50 nm, preferably thinner than 40 nm, more preferably thinner than 30 nm, even more preferably thinner than 20 nm, most preferably thinner than 15 nm, also preferably thinner than 10 nm and less but still preferably thinner than 5 nm.

29. Electronic device according to any of claims 21-28, wherein the electron transporting or electron injecting layer is adjacent to the light emitting layer consisting of compounds that have their reduction potentials, if measured by cyclic voltammetry under the same conditions, more negative than the electron transport matrix compounds of the adjacent electron transporting or electron injecting layer.

30. Electronic device according to any of claims 21-25, wherein the electron transporting or electron injecting layer is adjacent to a cathode consisting of a semiconducting metal oxide.

31. Electronic device according to claim 30, wherein the semiconducting metal oxide is indium tin oxide.

32. Electronic device according to any of claims 20-31, wherein the light emitting layer emits blue or white light.

33. Electronic device according to any of claims 20-32, wherein the light emitting layer comprises at least one polymer.

34. Electronic device according to claim 33, wherein the polymer is a blue light emitting polymer.

35. Compound selected from the group consisting of

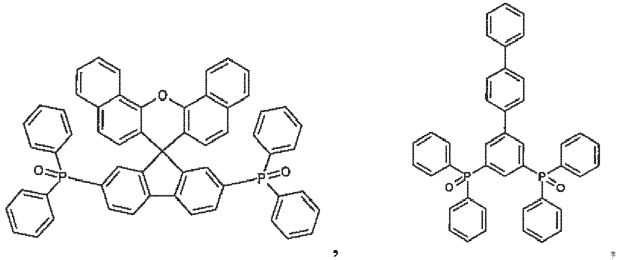

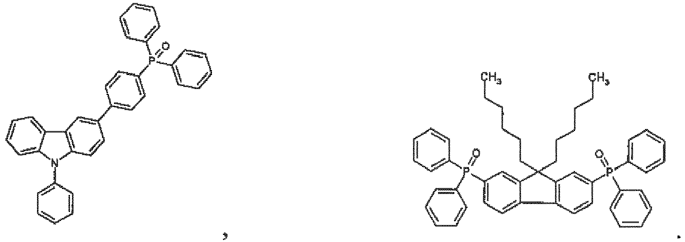

## Patentansprüche

1. Elektrisch dotiertes halbleitendes Material, das mindestens ein metallisches Element in seiner im Wesentlichen elementaren Form als n-Dotierungsmittel und mindestens eine Elektronentransportmatrix -Verbindung umfasst, die mindestens eine Phosphinoxidgruppe enthält, wobei das metallische Element aus Elementen ausgewählt wird, die in ihrer Oxidationszahl II mindestens eine stabile Verbindung bilden, und die Elektronentransportmatrix -Verbindung hat das Reduktionspotential, wenn es durch zyklische Voltammetrie unter denselben Bedingungen gemessen wird, das niedriger als Tris(4-benzo[d]thiazol-0-yl)phenoxyaltuninum, vorzugsweise niedriger als 9,9',10,10'-Tetraphenyl-2,2'-bianthracen oder 2,9-di([1,1'-Biphenyl]-1-yl)-4,7-diphenyl-1,10-phenanthrolin, besser niedriger als 2,4,7,9-Tetraphenyl-1,10-phenanthrolin, noch besser niedriger als 9,10-di(Naphthalen-1-yl)-1-phenylanthracen, am besten niedriger als 2,9-bis(1-Methoxyphenyl)-4,7-diphenyl- 1,10- phenanthrolin, immer noch vorzugsweise niedriger als 9,9'-Spirobi[fluorin]-2,7-diylbis(diphenylphosphinoxid) und höher als N1,N1,N1',N1',N4,N5,N6',NT-Octaphenyl-9,9'-spirobi[fluoren]-2,2',7,7'-tetraamin, vorzugsweise höher als Triphenylen, noch besser höher als N2,N3'-di(Naphthalen-7-yl)-N3,N3'-diphenyl-[1,1'-biphenyl]-4,4'-diamin, noch besser höher als 4,4'-di(6H-Carbazol-8-yl)-1,1*-biphenyl, am besten höher als bis(3-(8H-Carbazol-8-yl)phenyl)(phenyl)phosphinoxid, weniger, aber immer noch vorzugsweise höher als 1-([1,1'-Biphenyl]-8-yl)-3-(3-(tert-butyl)phenyl)-4-phenyl-4H-1,2,4-triazol und noch weniger, aber immer noch vorzugsweise höher als Pyren.

2. Elektrisch dotiertes halbleitendes Material nach Anspruch 1, wobei die Elektronentransportmatrix -Verbindung eine Verbindung nach Formel (I) ist: 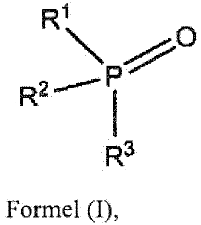 wobei R¹, R² und R³ unabhängig ausgewählt werden aus C₁-C₃₀-Alkyl, C₃-C₃₀-Cycloalkyl, C₂-C₃₀-Heteroalkyl, C₆-C₃₀-Aryl, C₂-C₃₀-Heteroaryl, C₁-C₃₀-Alkoxy, C₃-C₃₀-Cycloalkyloxy, C₆-C₃₀-Aryloxy, wobei jeder der Substituenten R¹, R² und R³ optional ferner Phosphinoxidgruppen umfassen, und mindestens einer der Substituenten R¹, R² und R³ umfasst ein konjugiertes System von mindestens 10 delokalisierten Elektronen.

3. Elektrisch dotiertes halbleitendes Material nach Anspruch 1 oder 2, wobei das metallische Element eine Summe seines ersten und zweiten Ionisationspotentials von weniger als 25 eV, vorzugsweise weniger als 24 eV, noch besser weniger als 23,5 eV, am besten weniger als 23,1 eV hat.

4. Elektrisch dotiertes halbleitendes Material nach einem der Ansprüche 2-3, wobei das konjugierte System von mindestens 10 delokalisierten Elektronen direkt an der Phosphinoxidgruppe befestigt ist.

5. Elektrisch dotiertes halbleitendes Material nach Anspruch 2 oder 3, wobei das konjugierte System von mindestens 10 delokalisierten Elektronen von der Phosphinoxidgruppe durch eine Abstandsgruppe A getrennt ist.

6. Elektrisch dotiertes halbleitendes Material nach Anspruch 5, wobei die Abstandsgruppe A eine divalente sechselementige aromatische carbocyclische oder heterocyclische Gruppe ist.

7. Elektrisch dotiertes halbleitendes Material nach Anspruch 6, wobei der Abstandshalter A ausgewählt wird aus Phenylen, Azin-2,4-diyl, Azin-2,5-diyl, Azin-2,6-diyl, 1,3-Diazin-2,4-diyl und 1,3-Diazin-2,5-diyl.

8. Elektrisch dotiertes halbleitendes Material nach einem der Ansprüche 2-7, wobei das konjugierte System von mindestens 10 delokalisierten Elektronen ein C₁₄-C₅₀-Aryl oder ein C₈-C₅₀-Heteroaryl ist.

9. Elektrisch dotiertes halbleitendes Material nach einem der Ansprüche 1-8, das ferner ein Metallsalz-Additiv umfasst, das aus mindestens einem Metallkation und mindestens einem Anion besteht.

10. Elektrisch dotiertes halbleitendes Material nach Anspruch 9, wobei das Metallkation Li+ oder Mg2+ ist.

11. Elektrisch dotiertes halbleitendes Material nach Anspruch 9 oder 10, wobei das Metallsalz-Additiv ausgewählt wird aus Metallkomplexen, die einen 5-, 6- oder 7-elementigen Ring umfassen, der ein Stickstoffatom und ein Sauerstoffatom enthält, das am Metallkation gebunden ist, und aus Komplexen ausgewählt, die die Struktur nach Formel (II) haben, 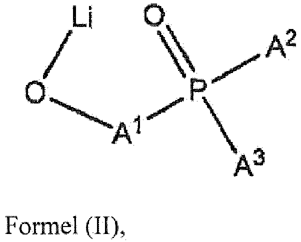 wobei A¹ ein C₆-C₃₀-Arylen oder C₂-C₃₀-Heteroarylen ist, das mindestens ein Atom enthält, welches aus O, S und N ausgewählt wird in einem aromatischen Ring, und jedes A² und A³ wird unabhängig ausgewählt aus einem C₆-C₃₀-Aryl und C₂-C₃₀-Heteroaryl, das mindestens ein Atom enthält, das aus O, S und N in einem aromatischen Ring ausgewählt wird.

12. Elektrisch dotiertes halbleitendes Material nach einem der Ansprüche 9-11, wobei das Anion ausgewählt wird aus der Gruppe bestehend aus Phenolat, substituiert mit einer Phosphinoxidgruppe, 8-Hydroxyquinolinolat und Pyrazolylborat.

13. Prozess zum Herstellen des halbleitenden Materials, das in einem der Ansprüche 1-12 definiert ist, das einen Schritt umfasst, bei dem die Elektronentransportmatrix-Verbindung, die mindestens eine Phosphinoxidgruppe enthält, und das metallische Element, das aus den Elementen ausgewählt wird, die in ihrer Oxidationszahl II mindestens eine stabile Verbindung bilden, unter reduziertem Druck gemeinsam verdampft und gemeinsam abgeschieden werden,
wobei die Elektronentransportmatrix-Verbindung ein Reduktionspotential hat, wenn dies durch zyklische Volatammetrie unter denselben Bedingungen gemessen wird, das niedriger als tris(2-Benzo[d]thiazol-2-yl)phenoxyaluminum, vorzugsweise niedriger als 9,9',10,10'-Tetraphenyl-2,2'-bianthracen oder 2,9-di([1,1'-Biphenyl]-4-yl)-4,7-diphenyl-1,10-phenanthrolin, besser niedriger als 2,4,7,9-Tetraphenyl-1,10-phenanthrolin, noch besser niedriger als 9,10-di(Naphthalen-2-yl)-2-phenylanthracen, am besten niedriger als 2,9-bis(2-Methoxyphenyl)-4,7-diphenyl-1,10-phenanthrolin, immer noch vorzugsweise niedriger als 9,9'-Spirobi[fluoren]-2,7-diylbis(diphenylphosphinoxid), und höher als N2,N2,N2',N2',N7,N7,N7',N7'-Octaphenyl-9,9'-spirobi[fluoren]-2,2',7,7'-tetraamin, vorzugsweise höher als Triphenylen, besser höher als 4,4'-di(911-Carbazol-9-yl)-1,1'-biphenyl, noch besser höher als bis(4-(9H-Carbazol-9-yl)phenyl)(phenyl)phosphinoxid, am besten höher als 3([1,1'-Biphenyl]-4-yl)-5-(4-(tert-butyl)phenyl)-4-phenyl-4H-1,2,4-triazol.

14. Prozess nach Anspruch 13, wobei das metallische Element ausgewählt wird aus Mg, Ca, Sr, Ba, Yb, Sm, Eu und Mn.

15. Prozess nach Anspruch 13 oder 14, wobei das metallische Element einen normalen Siedepunkt von unter 3000 °C, vorzugsweise unter 2200 °C, besser unter 1800 °C, am besten unter 1500 °C hat.

16. Prozess nach einem der Ansprüche 13-15, wobei das metallische Element eine Summe seines ersten und zweiten Ionisationspotentials von mehr als 16 eV hat, vorzugsweise mehr als 17 eV, besser mehr als 18 eV, noch besser mehr als 20 eV, am besten mehr als 21 eV, weniger, aber immer noch vorzugsweise mehr als 22 eV und sogar niedriger, asber immer noch vorzugsweise mehr als 23 eV.

17. Prozess nach einem der Ansprüche 13-16, wobei das metallische Element im Wesentlichen luftbeständig ist.

18. Prozess nach einem der Ansprüche 13-17, wobei das metallische Element von einer linearen Verdampfungsquelle verdampft wird.

19. Elektronische Vorrichtung, die eine Katode, eine Anode und das elektrisch dotierte halbleitende Material nach einem der Ansprüche 1-12 zwischen der katode und der Anode umfasst.

20. Elektronische Vorrichtung nach Anspruch 19, die ferner eine lichtemittierende Schicht zwischen der Katode und Anode umfasst.

21. Elektronische Vorrichtung nach Anspruch 19 oder 20, wobei das elektrisch dotierte halbleitende Material in einer Elektronentransport- oder elektroneninjizierenden Schicht enthalten ist.

22. Elektronische Vorrichtung nach Anspruch 21, wobei die elektronentransportierende oder elektroneninjizierende Schicht dicker als 5 nm ist, vorzugsweise dicker als 10 nm, besser dicker als 15 nm, noch besser dicker als 20 nm und am besten dicker als 25 nm.

23. Elektronische Vorrichtung nach Anspruch 21 oder 22, wobei die Elektronentransportschicht ein erstes Kompartiment umfasst, das näher an der lichtemittierenden Schicht ist, und ein zweites Kompartiment, das näher an der Katode ist, wobei sich das erste und zweite Fach in ihrer Zusammensetzung unterscheiden.

24. Elektronische Vorrichtung nach Anspruch 23, wobei das erste Kompartiment aus einer ersten elektronentransportierenden Matrix besteht.

25. Elektronische Vorrichtung nach Anspruch 23, wobei das erste Kompartiment die erste elektronentransportierende Matrix und ein Metallsalz-Additiv umfasst, das aus mindestens einem Metallkation und mindestens einem Anion besteht.

26. Elektronische Vorrichtung nach Anspruch 25, wobei das erste Kompartiment aus der ersten elektronentransportierenden Matrix und dem Metallsalz-Additiv besteht, und das zweite Kompartiment besteht aus dem elektrisch dotierten halbleitenden Material nach einem der Ansprüche 1-13 und 20.

27. Elektronische Vorrichtung nach Anspruch 26, wobei das zweite Kompartiment aus einer zweiten Elektronentransportmatrix und dem metallischen Element in seiner im Wesentlichen elementaren Form besteht.

28. Elektronische Vorrichtung nach einem der Ansprüche 24-27, wobei das erste Kompartiment dünner als 50 nm ist, vorzugsweise dünner als 40 nm, besser dünner als 30 nm, noch besser dünner als 15 nm, auch vorzugsweise dünner als 10 nm und weniger, aber immer noch vorzugsweise dünner als 5 nm.

29. Elektronische Vorrichtung nach einem der Ansprüche 21-28, wobei die elektronentransportierende oder elektroneninjizierende Schicht an die lichtemittierende Schicht grenzt, die aus Verbindungen besteht, deren Reduktionspotentiale, wenn durch zyklische Voltammetrie unter denselben Bedingungen gemessen, negativer als die Elektronentransportmatrix-Verbindungen der angrenzenden elektronentransportierenden oder elektroneninjizierenden Schicht.

30. Elektronische Vorrichtung nach einem der Ansprüche 21-25, wobei die elektronentransportierende oder elektroneninjizierende Schicht an eine Katode grenzt, die aus einem halbleitenden Metalloxid besteht.

31. Elektronische Vorrichtung nach Anspruch 30, wobei das halbleitende Metalloxid Indium-Zinn-Oxid ist.

32. Elektronische Vorrichtung nach einem der Ansprüche 20-31, wobei die lichtemittierende Schicht blaues oder weißes Licht emittiert.

33. Elektronische Vorrichtung nach einem der Ansprüche 20-32, wobei die lichtemittierende Schicht mindestens ein Polymer enthält.

34. Elektronische Vorrichtung nach Anspruch 33, wobei das Polymer ein blaues Licht emittierendes Polymer ist.

35. Verbindung, die aus der Gruppe ausgewählt wird, die besteht aus

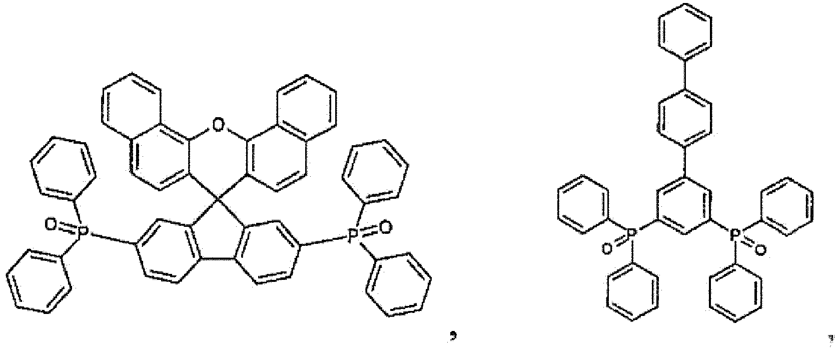

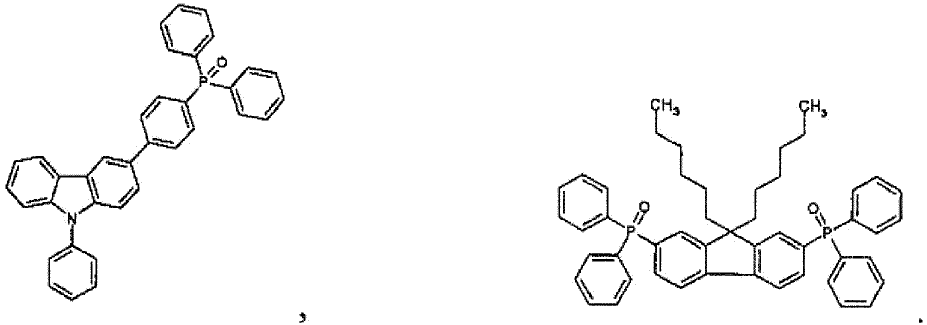

## Revendications

1. Matériau semi-conducteur électriquement dopé comprenant au moins un élément métallique dans sa forme substantiellement élémentaire en tant que n-dopant et au moins un composé matriciel de transport d'électrons comprenant au moins un groupe d'oxyde de phosphine, dans lequel l'élément métallique est choisi parmi des éléments qui forment dans leur nombre d'oxydation II au moins un composé stable et le composé matriciel de transport d'électrons possède le potentiel de réduction, lorsque mesuré par voltammétrie cyclique dans les mêmes conditions, inférieur au tris(2-benzo[d]thiazol-2-yl)phénoxyaluminum, de préférence inférieur au 9,9',10,10'-tétraphényl-2,2'-bianthracène ou à la 2,9-di([1,1'-biphényl]-4-yl)-4,7-diphényl-1,10-phénanthroline, plus préférablement inférieur à la 2,4,7, 9-tétraphényl-1,10-phénanthroline, encore plus préférablement inférieur au 9,10-di(naphtalèn-2-yl)-2-phénylanthracène, le plus préférablement inférieur à la 2,9-bis(2-méthoxyphényl)-4,7-diphényl-1,10-phénanthroline, encore plus préférablement inférieur à l'oxyde de 9,9'-spirobi[fluorène]-2,7-diylbis(diphénylphosphine), et supérieur à la N2,N2,N2',N2',N7,N7,N7',N7'-octaphényl-9,9'-spirobi[fluorène]-2,2',7,7'-tétraamine, de préférence supérieur au triphénylène, plus préférablement supérieur à la N4,N4'-di(naphtalèn-1-yl)-N4,N4'-diphényl-[1,1'-biphényl]-4,4'-diamine, encore plus préférablement supérieur au 4,4'-di(9H-carbazol-9-yl)-1,1'-biphényle, le plus préférablement supérieur à l'oxyde de bis(4-(9H-carbazol-9-yl)phényl)(phényl)phosphine, moins mais encore plus préférablement supérieur au 3-([1,1'-biphényl]-4-yl)-5-(4-(tert-butyl)phényl)-4-phényl-4H-1,2,4-triazole et encore moins mais encore préférablement supérieur au pyrène.

2. Matériau semi-conducteur électriquement dopé selon la revendication 1, dans lequel le composé matriciel de transport d'électrons est un composé selon la formule (I) : 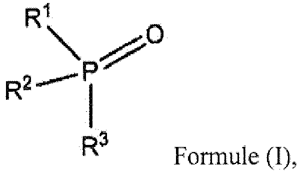 dans laquelle R¹, R² et R³ sont indépendamment choisis parmi C₁-C₃₀-alkyle, C₃-C₃₀-cycloalkyle, C₂-C₃₀-hétéroalkyle, C₆-C₃₀-aryle, C₂-C₃₀-hétéroaryle, C₁-C₃₀-alcoxy, C₃-C₃₀-cycloalkyloxy, C₆-C₃₀-aryloxy, dans lequel chacun des substituants R¹, R² et R³ comprend éventuellement d'autres groupes d'oxydes de phosphine et au moins un des substituants R¹, R² et R³ comprend un système conjugué composé d'au moins 10 électrons délocalisés.

3. Matériau semi-conducteur électriquement dopé selon la revendication 1 ou la revendication 2, dans lequel l'élément métallique a une somme de ses premier et second potentiels d'ionisation inférieure à 25 eV, de préférence inférieure à 24 eV, plus préférablement inférieure à 23,5 eV, bien plus préférablement inférieure à 23,1 eV.

4. Matériau semi-conducteur électriquement dopé selon la revendication 2 ou la revendication 3, dans lequel le système conjugué composé d'au moins 10 électrons délocalisés est attaché directement au groupe d'oxyde de phosphine.

5. Matériau semi-conducteur électriquement dopé selon la revendication 2 ou la revendication 3, dans lequel le système conjugué composé d'au moins 10 électrons délocalisés est séparé du groupe d'oxyde de phosphine par un groupe espaceur A.

6. Matériau semi-conducteur électriquement dopé selon la revendication 5, dans lequel le groupe espaceur A représente un groupe divalent carbocyclique ou hétérocyclique aromatique à 6 chaînons.

7. Matériau semi-conducteur électriquement dopé selon la revendication 6, dans lequel le groupe espaceur A est choisi parmi le phénylène, l'azine-2,4-diyle, l'azine-2,5-diyle, l'azine-2,6-diyle, le 1,3-diazine-2,4-diyle and le 1,3-diazine-2,5-diyle.

8. Matériau semi-conducteur électriquement dopé selon l'une quelconque des revendications 2 à 7, dans lequel le système conjugué composé d'au moins 10 électrons délocalisés est un C14-C50-aryle ou un C8-C50 hétéroaryle.

9. Matériau semi-conducteur électriquement dopé selon l'une quelconque des revendications 1 à 8, comprenant en outre un additif de sel métallique constitué d'au moins un cation métallique et d'au moins un anion.

10. Matériau semi-conducteur électriquement dopé selon la revendication 9, dans lequel le cation métallique est Li+ ou Mg2+.

11. Matériau semi-conducteur électriquement dopé selon la revendication 9 ou la revendication 10, dans lequel l'additif de sel métallique est choisi parmi des complexes métalliques comprenant un cycle à 5, 6 ou 7 chaînons qui contient un atome d'azote et un atome d'oxygène attachés au cation métallique et à partir de complexes possédant la structure selon la formule (II) 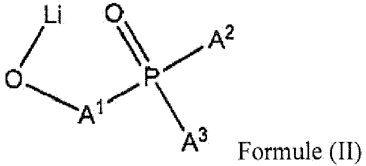 dans laquelle A¹ représente un C₆-C₃₀ arylène ou un C₂-C₃₀ hétéroarylène comprenant au moins un atome choisi parmi O, S et N dans un cycle aromatique et chacun des A² et A³ est indépendamment choisi parmi un C₆-C₃₀ aryle ou un C₂-C₃₀ hétéroaryle comprenant au moins un atome choisi parmi O, S et N dans un cycle aromatique.

12. Matériau semi-conducteur électriquement dopé selon l'une quelconque des revendications 9 à 11, dans lequel l'anion est choisi parmi le groupe constitué du phénolate substitué par un groupe d'oxyde de phosphine, du 8-hydroxyquinolinolate et du pyrazolylborate.

13. Processus de fabrication du matériau semi-conducteur défini selon l'une quelconque des revendications 1 à 12, comprenant une étape où le composé matriciel de transport d'électrons comprenant au moins un groupe d'oxydes de phosphine et l'élément métallique choisi parmi des éléments qui forment dans leur nombre d'oxydation II au moins un composé stable sont coévaporés et codéposés sous pression réduite,
dans lequel le composé de matriciel de transport d'électrons possède un potentiel de réduction, lorsque mesuré par voltammétrie cyclique dans les mêmes conditions, inférieur au tris(2-benzo[d]thiazol-2-yl)phénoxyaluminum, de préférence inférieur au 9,9',10,10'-tétraphényl-2,2'-bianthracène ou à la 2,9-di([1,1'-biphényl]-4-yl)-4,7-diphényl-1,10-phénanthroline, plus préférablement inférieur à la 2,4,7, 9-tétraphényl-1,10-phénanthroline, encore plus préférablement inférieur au 9,10-di(naphtalèn-2-yl)-2-phénylanthracène, le plus préférablement inférieur à la 2,9-bis(2-méthoxyphényl)-4,7-diphényl-1,10-phénanthroline, encore plus préférablement inférieur à l'oxyde de 9,9'-spirobi[fluorène]-2,7-diylbis(diphénylphosphine), et supérieur à la N2,N2,N2',N2',N7,N7,N7',N7'-octaphényl-9,9'-spirobi[fluorène]-2,2',7,7'-tétraamine, de préférence supérieur au triphénylène, plus préférablement supérieur à la N4,N4'-di(naphtalèn-1-yl)-N4,N4'-diphényl-[1,1'-biphényl]-4,4'-diamine, encore plus préférablement supérieur au 4,4'-di(9H-carbazol-9-yl)-1,1'-biphényle, encore plus préférablement supérieur à l'oxyde de bis(4-(9H-carbazol-9-yl)phényl)(phényl)phosphine, le plus préférablement supérieur au 3-([1,1'-biphényl]-4-yl)-5-(4-(tert-butyl)phényl)-4-phényl-4H-1,2,4-triazole.

14. Processus selon la revendication 13, dans lequel l'élément métallique est choisi parmi Mg, Ca, Sr, Ba, Yb, Sm, Eu et Mn.

15. Processus selon la revendication 13 ou la revendication 14, dans laquelle l'élément métallique possède un point d'ébullition normal inférieur à 3000 °C, de préférence inférieur à 2200 °C, plus préférablement inférieur à 1800 °C, le plus préférablement inférieur à 1500 °C.

16. Processus selon l'une quelconque des revendications 13 à 15, dans lequel l'élément métallique possède une somme de ses premiers et seconds potentiels d'ionisation supérieure à 16 eV, de préférence supérieure à 17 eV, plus préférablement supérieure à 18 eV, encore plus préférablement supérieure à 20 eV, le plus préférablement supérieure à 21 eV, moins mais encore préférablement supérieure à 22 eV et même moins mais encore préférablement supérieure à 23 eV.

17. Processus selon l'une quelconque des revendications 13 à 16, dans lequel l'élément métallique est essentiellement stable à l'air.

18. Processus selon l'une quelconque des revendications 13 à 17, dans lequel l'élément métallique est évaporé à partir d'une source d'évaporation linéaire.

19. Dispositif électronique comprenant une cathode, une anode et le matériau semi-conducteur électriquement dopé selon l'une quelconque des revendications 1 à 12 entre la cathode et l'anode.

20. Dispositif électronique selon la revendication 19, comprenant en outre une couche émettrice de lumière entre la cathode et l'anode.

21. Dispositif électronique selon la revendication 19 ou la revendication 20, dans lequel le matériau semi-conducteur électriquement dopé et compris d'une couche de transport d'électrons ou d'une couche d'injection d'électrons.

22. Dispositif électronique selon la revendication 21, dans lequel la couche de transport d'électrons ou la couche d'injection d'électrons possède une épaisseur supérieure à 5 nm, de préférence supérieure à 10 nm, plus préférablement supérieure à 15 nm, encore plus préférablement supérieure à 20 nm et le plus préférablement supérieure à 25 nm.

23. Dispositif électronique selon la revendication 21 ou la revendication 22, dans lequel la couche de transport d'électrons comprend un premier compartiment plus proche de la couche émettrice de lumière et un second compartiment plus proche de la cathode, le premier et le second comportements étant différents en terme de composition.

24. Dispositif électronique selon la revendication 23, dans lequel le premier compartiment est constitué d'une première matrice de transport d'électrons.

25. Dispositif électronique selon la revendication 23, dans lequel le premier compartiment comprend la première matrice de transport d'électrons et un additif de sel métallique constitué d'au moins un cation métallique et d'au moins un anion.

26. Dispositif électronique selon la revendication 25, dans lequel le premier compartiment est constitué de la première matrice de transport d'électrons et de l'additif de sel métallique et le second compartiment est constitué du matériau semi-conducteur électriquement dopé selon l'une quelconque des revendications 1 à 13 et selon la revendication 20.

27. Dispositif électronique selon la revendication 26, dans lequel le second compartiment est constitué d'une seconde matrice de transport d'électrons et de l'élément métallique dans sa forme substantiellement élémentaire.

28. Dispositif électronique selon l'une quelconque des revendications 24 à 27, dans lequel le premier compartiment possède une épaisseur inférieure à 50 nm, de préférence inférieure à 40 nm, plus préférablement inférieure à 30 nm, encore plus préférablement inférieure à 20 nm, le plus préférablement inférieure à 15 nm, et de préférence inférieure à 10 nm et moins mais encore préférablement inférieure à 5 nm.

29. Dispositif électronique selon l'une quelconque des revendications 21 à 28, dans lequel la couche de transport d'électrons ou la couche d'injection d'électrons est adjacente à la couche émettrice de lumière constituée de composés qui possèdent des potentiels de réduction, si mesurés par voltammétrie cyclique dans les mêmes conditions, plus négatifs que les composés matriciels de transport d'électrons de la couche de transport d'électrons ou de la couche d'injection d'électrons adjacentes.

30. Dispositif électronique selon l'une quelconque des revendications 21 à 25, dans lequel la couche de transport d'électrons ou la couche d'injection d'électrons est adjacente à une cathode constituée d'un oxyde métallique semi-conducteur.

31. Dispositif électronique selon la revendication 30, dans lequel l'oxyde métallique semi-conducteur est l'oxyde d'indium étain.

32. Dispositif électronique selon l'une quelconque des revendications 20 à 31, dans lequel la couche émettrice de lumière émet de la lumière bleue ou blanche.

33. Dispositif électronique sur l'une quelconque des revendications 20 à 32, dans lequel la couche émettrice de lumière comprend au moins un polymère.

34. Dispositif électronique selon la revendication 33, dans lequel le polymère est un polymère émettant de la lumière bleue.

35. Composé choisi parmi le groupe constitué de
